(19) Europäisches Patentamt
European Patent Office
Office européen des brevets

(11) **EP 2 592 750 A1**

(12) **EUROPEAN PATENT APPLICATION**
published in accordance with Art. 153(4) EPC

(43) Date of publication:
**15.05.2013 Bulletin 2013/20**

(51) Int Cl.:
*H03F 1/32* *(2006.01)*    *H03F 3/189* *(2006.01)*
*H03F 3/24* *(2006.01)*    *H04B 1/04* *(2006.01)*
*H04J 11/00* *(2006.01)*    *H04L 27/01* *(2006.01)*
*H04L 27/20* *(2006.01)*

(21) Application number: **12747450.0**

(22) Date of filing: **13.02.2012**

(86) International application number:
**PCT/JP2012/053213**

(87) International publication number:
**WO 2012/111583 (23.08.2012 Gazette 2012/34)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.02.2011 JP 2011033746
24.05.2011 JP 2011115923**

(71) Applicant: **NTT DoCoMo, Inc.
Tokyo 100-6150 (JP)**

(72) Inventors:
• **OHKAWARA, Junya
Tokyo 100-6150 (JP)**

• **SUZUKI, Yasunori
Tokyo 100-6150 (JP)**
• **NARAHASHI, Shoichi
Tokyo 100-6150 (JP)**
• **FURUTA, Takayuki
Tokyo 100-6150 (JP)**

(74) Representative: **MERH-IP
Matias Erny Reichl Hoffmann
Paul-Heyse-Strasse 29
80336 München (DE)**

(54) **POWER SERIES DIGITAL PREDISTORTER AND CONTROL METHOD THEREOF**

(57) A PAPR observation unit that measures PAPR in a distributed output of an input signal and PAPR in a combined output of a linear transmission path and a third order distortion generation path, a distortion observation unit that observes distortion in the output of a power amplifier, and a controller are provided, where the controller includes a third order out-of-band distortion compensation coefficient control unit that adjusts coefficients corresponding to an outside of an input signal band among frequency characteristic compensator coefficients on the basis of distortion observed by the distortion observation unit and a third order in-band distortion coefficient control unit that adjusts coefficients corresponding to an inside of the input signal band among frequency characteristic compensator coefficients on the basis of the observed PAPR.

FIG. 5

EP 2 592 750 A1

**Description**

[TECHNICAL FIELD]

The present invention relates to a power series digital predistorter and a control method thereof.

[BACKGROUND ART]

In mobile communications, a transmission power amplifier (hereinafter, a power amplifier) is an important radio circuit which has a role to amplify a transmission signal outputted from a transmission antenna of a base station or a mobile station to predetermined power. A power amplifier handles large power, so that the power amplifier is desired to exhibit high power efficiency.

Commonly, an operating point of a power amplifier is set close to saturation output, in other words, output back-off indicating a margin from saturation output of the power amplifier is reduced so as to obtain highly-efficient operation of the power amplifier. At this time, out-of-band distortion components (hereinafter, distortion components) are generated due to non-linearity of the power amplifier. Especially, as an operating point of the power amplifier is set closer to saturation output, distortion components are increased. Further, distortion components have frequency dependency.

On the other hand, regarding a power amplifier input signal, OFDM (quadrature frequency division multiplexing) transmission has received attention in recent years from a viewpoint of frequency usage efficiency. Though an OFDM signal exhibits high frequency usage efficiency, the OFDM signal has a high peak-to-average power ratio (PAPR). A power amplifier cannot amplify a power amplifier input signal over saturation output. Therefore, when output back-off is lower than a PAPR of a power amplifier input signal, a waveform of the power amplifier output signal is clipped. In this case as well, distortion components are generated in the power amplifier output signal.

Distortion components interfere with a radio communication system which uses adjacent frequency bands. Therefore, it is necessary to reduce distortion components up to the level defined by a specification of various types of radio communication systems.

As a method for reducing (also referred to as compensating) distortion components which are generated due to non-linearity of the power amplifier, there is a distortion compensating method as typified by a predistortion method. In the predistortion method, distortion compensation components which cancel distortion components generated in the power amplifier are added to a power amplifier input signal with a predistorter. Examples of the predistorter which compensates distortion components having frequency dependency include a power series digital predistorter (hereinafter, referred to as a digital predistorter) which compensates for frequency dependency of distortion components (for example, non-patent literature 1).

On the other hand, distortion components which are generated by waveform clip cannot be compensated for by the distortion compensating method. This is because the power amplifier cannot amplify a signal over saturation output. Examples of a method for reducing distortion components include a PAPR reducing method as typified by a method using clipping and filtering. In the method using clipping and filtering, after a waveform is clipped so that an amplitude value of a power amplifier input signal becomes equal to or less than a predetermined threshold value on a preceding stage of a predistorter, distortion components which are generated by clipping are reduced by filtering (for example, non-patent literature 2).

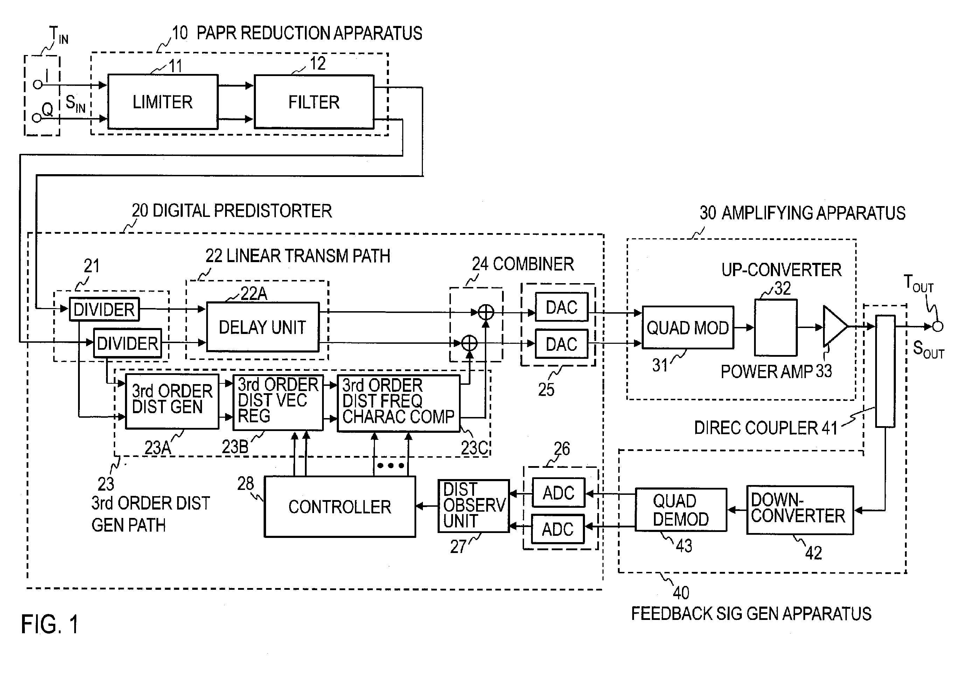

Fig. 1 illustrates each of a conventional configuration example of a PAPR reduction apparatus using clipping and filtering, a conventional configuration example of a digital predistorter, and peripheral devices of the digital predistorter. In this example, a case where digital signals (sample lines) composed of an I phase and a Q phase are inputted into an input terminal $T_{IN}$ as input signals $S_{IN}$ is illustrated.

A PAPR reduction apparatus 10 is composed of a limiter 11 and a filter 12. When an amplitude value of an input signal $S_{IN}$ to the PAPR reduction apparatus 10 is larger than a predetermined threshold value, the limiter 11 clips the amplitude value of the input signal $S_{IN}$ at the threshold value. The filter 12 suppresses distortion components which are generated by the limiter 11. Commonly, in the PAPR reducing method using clipping and filtering, an amplitude value which exceeds the threshold value is regenerated due to filtering, so that clipping and filtering are repeated until a desired PAPR is obtained.

A digital predistorter 20 includes a divider 21, a linear transmission path 22, a third order distortion generation path 23, a combiner 24, a digital-analog converter (hereinafter, DAC) 25, an analog-digital converter (hereinafter, ADC) 26, a distortion observation unit 27, and a controller 28. The linear transmission path 22 includes a delay unit 22A. The third order distortion generation path 23 includes a third order distortion generator 23A, a third order distortion vector regulator 23B, and a third order distortion frequency characteristic compensator 23C. The divider 21 distributes signals $S_{IN}$ composed of the I phase and the Q phase output from the PAPR reduction apparatus 10 to the linear transmission path 22 and the third order distortion generation path 23. The combiner 24 combines output of the linear transmission path 22 and output of the third order distortion generation path 23. The DAC 25 converts output of the combiner 24 (digital signals of the I phase and the Q phase to which distortion compensation components are added) into analog signals of the I phase and the Q phase. The ADC 26 converts output (analog signals of the I phase and the Q phase) of a feedback signal generating apparatus 40, which takes in part of output $S_{OUT}$ of an amplifying apparatus 30 as a feedback signal, into digital signals of the I phase and the Q phase. The distortion observation unit 27 detects distortion components from output of the ADC 26. The controller 28 adjusts third order distortion vector regulator coefficients (an amplitude value and a phase value) which are to be set in the third order distortion vector regulator 23B and a plurality of third order distortion frequency characteristic compensator coefficients (amplitude values and phase values) which are to be set in the third order distortion frequency characteristic compensator 23C, on the basis of output of the distortion observation unit 27.

The amplifying apparatus 30 includes a quadrature modulator 31 which performs quadrature modulation on analog signals of the I phase and the Q phase which are output of the digital predistorter, an up-converter 32 which up-converts a frequency of the modulated output to a carrier frequency, and a power amplifier 33 which power-amplifies the frerquency-converted high-frequency signal. The high-frequency signal which is power-amplified is supplied from an output terminal $T_{OUT}$ to an antenna as an output signal $S_{OUT}$ via a duplexer which is not depicted, for example.

The feedback signal generating apparatus 40 includes a directional coupler 41 which takes out part of output $S_{OUT}$ of the amplifying apparatus 30 as a feedback signal, a down-converter 42 which down-converts a frequency of the feedback signal, and a quadrature demodulator 43 which performs quadrature demodulation on the down-converted feedback signal to analog signals of the I phase and the Q phase.

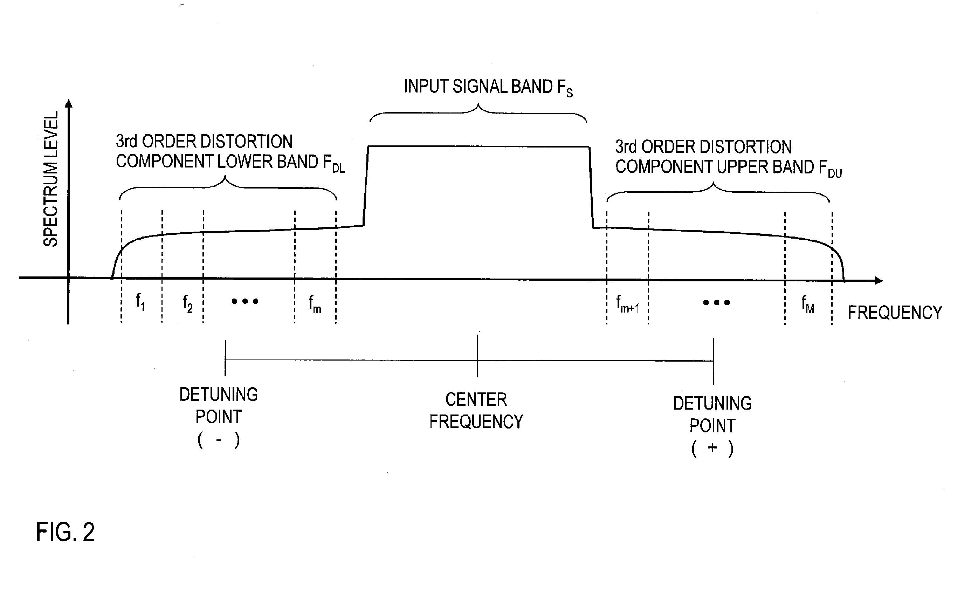

The third order distortion generator 23A cubes a signal distributed from the divider 21 so as to generate third order distortion components. The third order distortion vector regulator 23B multiplies third order distortion components generated in the third order distortion generator 23A by third order distortion vector regulator coefficients provided from the controller 28 so as to adjust a phase and amplitude of the third order distortion components. The third order distortion frequency characteristic compensator 23C multiplies respective bands (band $f_1$ to band $f_M$), which are obtained by dividing a third order distortion component upper band $F_{DU}$ and a third order distortion component lower band $F_{DL}$ into M divided bands in total, as depicted in Fig 2, by third order distortion frequency characteristic compensator coefficients which are provided from the controller 28 and are different from each other. An input signal band $F_S$ of Fig. 2 includes an input signal $S_{IN}$ fed from the input terminal $T_{IN}$ via the PAPR reduction apparatus 10, the digital predistorter 20, and the amplifying apparatus 30.

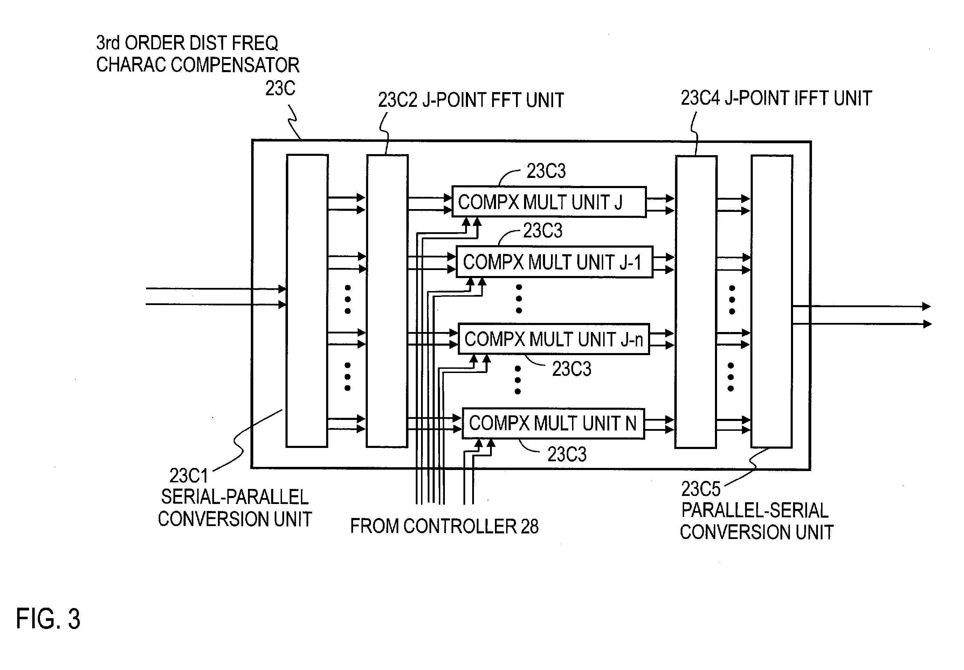

Fig. 3 illustrates a configuration example of the third order distortion frequency characteristic compensator 23C. The third order distortion frequency characteristic compensator 23C includes a serial-parallel conversion unit 23C1, a J-point FFT (fast fourier transform) unit 23C2, J ($J{\geq}M$) complex multiplication units 23C3, a J-point IFFT (inverse fast fourier transform) unit 23C4, and a parallel-serial conversion unit 23C5. The serial-parallel conversion unit 23C1 serial-parallel-converts an input signal from the third order distortion vector regulator 23B. The J-point FFT unit 23C2 converts input signals from the serial-parallel conversion unit 23C1 from a time domain into a frequency domain for every J samples. An output signal corresponding to the band $f_1$ among output of the J-point FFT unit 23C2 is inputted into one of the complex multiplication units 23C3 corresponding to the band $f_1$ and is multiplied by third order distortion frequency characteristic compensator coefficients which are provided by the controller 28, so as to adjust amplitude and a phase. The same applies to each of the bands $f_2$ to $f_M$ as well. At this time, outputs of the J-point FFT units 23C2 which do not correspond to M divided bands (that is, outputs corresponding to the input signal band $F_S$, outputs corresponding to a band lower than the band $f_1$, and outputs corresponding to a band higher than the band $f_M$) are inputted into the J-point IFFT unit 23C4 without being multiplied by coefficients at the complex multiplication units. The J-point IFFT unit 23C4 converts input signals received from the preceding stage from a frequency domain into a time domain for every J samples. The parallel-serial conversion unit 23C5 parallel-serial-converts input signals from the J-point IFFT unit 23C4 for every J samples.

The controller 28 adjusts a third order distortion vector regulator coefficients which are to be provided to the third order distortion vector regulator 23B and a third order distortion frequency characteristic compensator coefficients which are to be provided to the third order distortion frequency characteristic compensator, so as to minimize distortion components generated in the power amplifier 33 (or make distortion components equal to or less than a predetermined threshold value).

[PRIOR ART LITERATURE]

[NON-PATENT LITERATURE]

Non-patent literature 1: S. Mizuta, Y. Suzuki, S. Narahashi, and Y. Yamao, "A New Adjustment Method for the Frequency-Dependent IMD Compensator of the Digital Predistortion Linearizer," IEEE Radio and Wireless Symposium 2006, pp. 255 - 258, Jan. 2006.

Non-patent literature 2: Xiaodong Li and Cimini, L.J., Jr., "Effects of clipping and filtering on the performance of OFDM," 47th IEEE Vehicular Technology Conference 1997, pp. 1634 - 1638, May. 1997.

[SUMMARY OF THE INVENTION]

[PROBLEMS TO BE SOLVED BY THE INVENTION]

In the digital predistorter, output of the liner transmission path and output of the third order distortion generation path are combined by a combiner. At this time, there is a case where PAPR of a combiner output signal is increased depending on third order distortion vector regulator coefficients to be provided to the third order distortion vector regulator or third order distortion frequency characteristic compensator coefficients to be provided to the third order distortion frequency characteristic compensator. This indicates increase in PAPR in the output of the digital predistorter. When a PAPR is increased to exceed an output backoff of the power amplifier, distortion components which cannot be compensated for by the digital predistorter are generated as mentioned above. Therefore, it is necessary to reduce a PAPR again by the PAPR reduction apparatus so that PAPR of the digital predistorter output signal becomes equal to or less than the output backoff (or equal to or less than a desired value). From above, when PAPR in the output of the digital predistorter is increased to exceed the output backoff, there arises a problem of increase in an amount of calculations related to signal processing for reducing PAPR. When the amount of calculations is increased, calculation time of a signal processing circuit is disadvantageously increased. A use of a signal processing circuit exhibiting high signal processing performance is one of methods to solve this problem, but this method causes increase of cost and power consumption of the signal processing circuit.

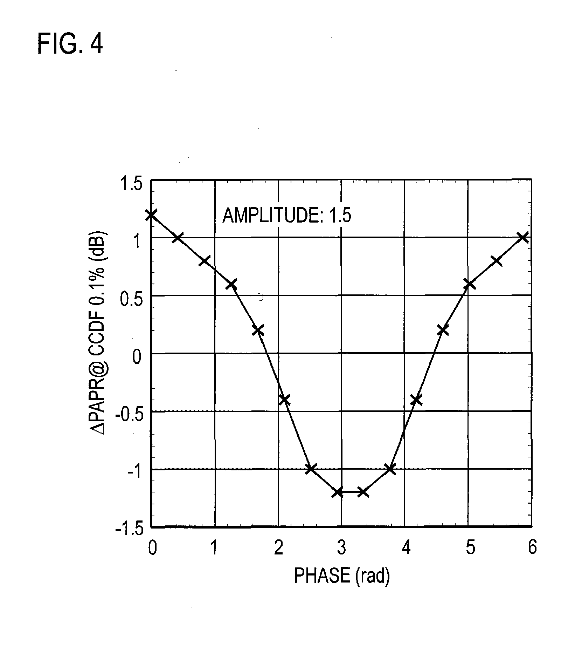

Fig. 4 illustrates a calculation result of a fluctuating amount of PAPR in an output signal of the digital predistorter. In this example, an OFDM signal (bandwidth 3.84 MHz) which had 64 subcarriers and of which a modulating method was QPSK was used. The PAPR fluctuating amount of an output signal was calculated by using an input signal of the digital predistorter as a reference. The vertical axis represents a PAPR fluctuating amount when the complementary cumulative distribution function (CCDF) is 0.1%. The horizontal axis represents a phase value provided to the third order distortion vector regulator. At this time, an amplitude value to be provided to the third order distortion vector regulator was set to 1.5 and all phase values and amplitude values provided to the third order distortion frequency characteristic compensator were respectively set to 0 and 1. From the result, it can be understood that when a phase value to be provided to the third order distortion vector regulator was set to 0, PAPR of a digital predistorter output signal was increased by 1.2 dB. Accordingly, it is an object of the present invention to provide a power series digital predistorter which can suppress increase in PAPR which is caused by frequency characteristic compensation, and a controlling method of the power series digital predistorter.

[MEANS TO SOLVE THE PROBLEMS]

According to the present invention, a power series digital predistorter that adds distortion compensation components for cancelling distortion components generated in a power amplifier, to an input signal includes:

a liner transmission path configured to delay and transmit the input signal,
a distortion generation path configured to include an N-th order distortion generator that generates an N-th order distortion component of the input signal, an N-th order distortion vector regulator that adjusts amplitude and a phase of the N-th order distortion component, and an N-th order distortion frequency characteristic compensator that converts output of the N-th order distortion vector regulator into a frequency domain, adjusts a phase and amplitude of each frequency component respectively, inverse-converts the adjusted frequency components into a time domain, and outputs an output of the N-th order distortion frequency characteristic compensator as the distortion compensation components, N being a predetermined odd number equal to or greater than 3,
a combiner configured to combine an output of the linear transmission path and an output of the distortion generation path,
a PAPR observation unit configured to calculate at least a ratio of average power to peak power $PAPR_{OUT}$ in an output signal of the combiner,
a distortion observation unit configured to observe at least an N-th order distortion component included in an output of the power amplifier, and
a controller configured to adjust a phase value and an amplitude value with respect to the N-th order distortion vector regulator and the N-th order distortion frequency characteristic compensator on the basis of an observation result of the PAPR observation unit and the distortion observation unit.

[EFFECTS OF THE INVENTION]

(1) Thus, according to the present invention, a PAPR in the output of the combiner is observed, and a phase and amplitude of the N-th order distortion component in the input signal band are respectively adjusted on the basis of the observed PAPR. Accordingly, a PAPR can be prevented from becoming larger than a reference by setting a phase value and an amplitude value in the N-th order distortion vector regulator. In addition, a PAPR can be prevented from becoming larger than a reference by respectively setting a phase value and an amplitude value in the N-th order distortion frequency characteristic compensator so that N-th order distortion components on the upper side and the lower side of the input signal band are decreased.

Further, according to the present invention, a PAPR can be reduced by the digital predistorter. Therefore, (2) when a PAPR of the digital predistorter output signal is increased, an amount of calculations related to signal processing can be reduced compared to a case where a PAPR is reduced on a preceding stage of the digital predistorter.

(3) When a PAPR can be made equal to or less than a desired value only by the digital predistorter without using a PAPR reduction apparatus, an amount of calculations related to the PAPR reduction apparatus can be decreased.
(4) A PAPR can be further reduced by combining with the PAPR reduction apparatus, so that the output backoff of the power amplifier can be further reduced compared to a case where only the PAPR reduction apparatus is used. That is, the power amplifier can be operated further highly efficiently.

Trial calculations of an efficiency improvement amount in a case where the power amplifier is B-class-operated are described below. It is assumed that the maximum efficiency of the power amplifier is 78.5% which is a theoretical value, output backoff is 8 dB, and output backoff can be reduced by the same amount as a PAPR reducing amount without increase in distortion components. Here, efficiency of the power amplifier is 31.3%. When it is assumed that a PAPR can be reduced by 1 dB, efficiency is 35.1%, being improved by 3.8%. Further, when a PAPR can be reduced by 2 dB, efficiency is 39.3%, obtaining improvement of 8.0%.

[BRIEF DESCRIPTION OF THE DRAWINGS]

Fig. 1 is a block diagram illustrating a configuration example of a PAPR reduction apparatus of related art using clipping and filtering and a configuration example of a digital predistorter of related art;
Fig. 2 illustrates band division of a frequency characteristic compensator;
Fig. 3 is a block diagram illustrating a configuration example of the frequency characteristic compensator;
Fig. 4 is a graph illustrating a calculation result example of a PAPR changing amount in an output signal of the digital predistorter;
Fig. 5 is a block diagram illustrating a configuration example of a digital predistorter according to a first embodiment;
Fig. 6 is a block diagram illustrating a configuration example of a frequency characteristic compensator in the first embodiment;
Fig. 7 is a block diagram of a controller in the first embodiment;
Fig. 8 is a processing flow diagram of the controller in the first embodiment;
Fig. 9 illustrates a definition of an ACLR;
Fig. 10 is a block diagram illustrating a simple model of the digital predistorter used for description of a principle of the invention;
Fig. is a graph illustrating peak power reduction amount calculation result in an output signal of the digital predistorter in the simple model;
Fig. 12 is a processing flow diagram of a third order distortion vector regulator coefficient control unit in the first embodiment;
Fig. 13 is a processing flow diagram of a third order in-band distortion coefficient control unit in the first embodiment;
Fig. 14 is a processing flow diagram of a third order out-of-band distortion compensation coefficient control unit in the first embodiment;
Fig. 15A is a graph illustrating an example of a CCDF measurement result of a case where average output power of a power amplifier is 21.2 dBm in an experiment using the first embodiment;
Fig. 15B is a graph illustrating an example of a CCDF measurement result of a case where average output power of the power amplifier is 22.1 dBm in an experiment using the first embodiment;
Fig. 15C is a graph illustrating an example of a CCDF measurement result of a case where average output power of the power amplifier is 23.1 dBm in an experiment using the first embodiment;
Fig. 16 illustrates a division example of a third order distortion frequency characteristic compensator used in an experiment using the first embodiment;

Fig. 17 illustrates an example of measurement result of power amplifier output power to an ACLR in an experiment using the first embodiment;

Fig. 18 illustrates a power amplifier output spectrum example according to an experiment using the first embodiment;

Fig. 19 is a block diagram of a digital predistorter according to a second embodiment;

Fig. 20 is a processing flow diagram of a controller in the second embodiment;

Fig. 21 is a processing flow diagram of a third order in-band distortion coefficient control unit in the second embodiment;

Fig. 22 is a block diagram of a digital predistorter according to a modification of the second embodiment;

Fig. 23 is a block diagram of a controller in the modification of the second embodiment;

Fig. 24 is a processing flow diagram of a third order in-band distortion coefficient processing unit in the modification of the second embodiment;

Fig. 25 is a block diagram of a digital predistorter according to a third embodiment;

Fig. 26 is a block diagram of a controller in the third embodiment;

Fig. 27 is a processing flow diagram of the controller in the third embodiment;

Fig. 28 is a processing flow diagram of a third order in-band distortion coefficient control unit in the third embodiment;

Fig. 29 is a specific processing flow diagram of a third order in-band distortion coefficient control unit in the third embodiment;

Fig. 30 is a block diagram of a digital predistorter according to a modification of the third embodiment;

Fig. 31 is a block diagram of a controller in the modification of the third embodiment;

Fig. 32 is a processing flow diagram of a third order in-band distortion coefficient control unit in the modification of the third embodiment;

Fig. 33 is a block diagram of a digital predistorter according to a fourth embodiment; and

Fig. 34 is a block diagram of a controller in the fourth embodiment.

[DETAILED DESCRIPTION OF THE EMBODIMENTS]

[First Embodiment]

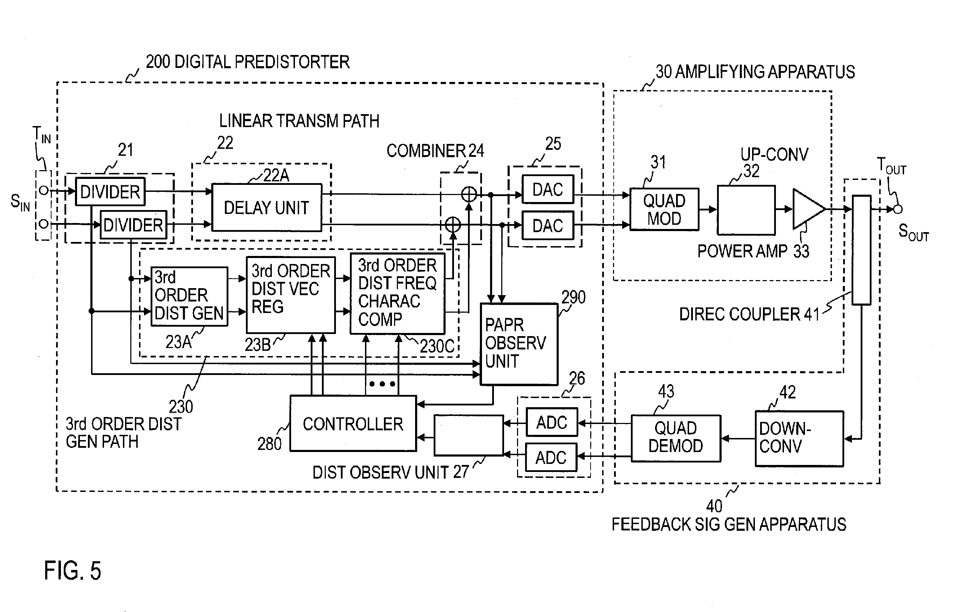

Fig. 5 illustrates a digital predistorter 200 and peripheral devices of the digital predistorter 200 according to a first embodiment. The peripheral devices of Fig. 5 are an amplifying apparatus 30 and a feedback signal generating apparatus 40 which takes in part of output of the amplifying apparatus 30 so as to generate a signal returning to the digital predistorter. The amplifying apparatus 30 and the feedback signal generating apparatus 40 are the same as the peripheral devices of the digital predistorter described as a related art in Fig. 1. In this embodiment, description is provided on the assumption that as a digital input signal (hereinafter, referred to merely as an input signal or a transmission signal) $S_{IN}$ of the digital predistorter 200, use is made of an OFDM signal which has a bandwidth of 3.84 MHz and which contains 64 subcarriers whose a modulating scheme is QPSK respectively. Here, a bandwidth of the transmission signal $S_{IN}$, the number of subcarriers, and a modulating scheme may be arbitrarily set and a signal, which employs other communication method, such as a WCDMA signal may be used instead of an OFDM signal.

The digital predistorter 200 includes a linear transmission path 22, an Nth order distortion generation path 230, a divider 21, a combiner 24, a PAPR observation unit 290, a DAC 25, an ADC 26, a distortion observation unit 27, and a controller 280. The linear transmission path 22 includes a delay unit 22A. The Nth order distortion generation path 230 includes an Nth order distortion generator 23A (N is an odd number equal to or larger than 3 and the drawing illustrates a case of N=3), an Nth order distortion vector regulator 23B, and an Nth order distortion frequency characteristic compensator 230C. The divider 21 distributes transmission signals $S_{IN}$ of an I phase and a Q phase to the linear transmission path 22 and the Nth order distortion generation path 230. The combiner 24 combines output from the linear transmission path 22 and output from the Nth order distortion generation path 230. The PAPR observation unit 290 measures peak power $P_{Pin}$ and $P_{Pout}$ and average power $P_{AVin}$ and $P_{AVout}$ respectively from output from the divider 21 and output from the combiner 24 so as to calculate PAPRs in the output of the divider 21 and the output of the combiner 24, that is, $PAPR_{IN}=P_{Pin}/P_{AVin}$ (or $PAPR_{IN}=10\log_{10}(P_{Pin}/P_{AVin})$) and $PAPR_{OUT}=P_{Pout}/P_{AVout}$ (or $PAPR_{OUT}=10\log_{10}(P_{Pout}/P_{AVout})$). The DAC 25 digital-analog-converts the output from the combiner 24. The ADC 26 analog-digital-converts respective analog signals of the I phase and the Q phase outputted from the feedback signal generating apparatus 40, which takes out part of the output signal $S_{OUT}$ from the amplifying apparatus 30, as a feedback signal. The distortion observation unit 27 measures power of a transmission signal which is inputted into the digital predistorter 200 and amplified by the power amplifier 33 and measures power of distortion components which are generated by the power amplifier 33 for every predetermined arbitrary frequency band $f_m$, from an output signal from the ADC 26. The controller 280 adjusts each of Nth order distortion vector regulator coefficients composed of a phase value and an amplitude value, a plurality of Nth order out-of-band distortion compensation coefficients composed of phase values and amplitude values, and a plurality of Nth order in-band distortion coefficients composed of phase values and amplitude values. A case of N=3 is described as an example below. Therefore, constituent elements are the same as the respective constituent elements of the digital predistorter of the related art depicted in Fig. 1 except for constituent elements which are the PAPR observation unit 290, the third order distortion frequency characteristic compensator 230C of the third order distortion generation path 230, and the controller 280, so that description below will be minimized as appropriate.

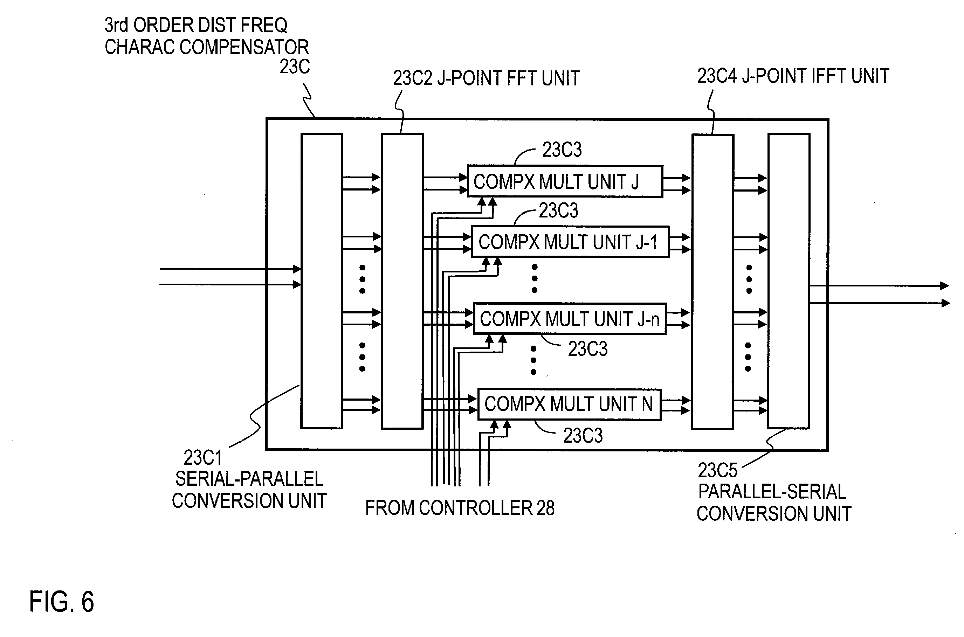

As depicted in Fig. 6, the configuration of the third order distortion frequency characteristic compensator 230C according to the embodiment is the same as that of the third order distortion frequency characteristic compensator 23C depicted in Fig. 3, except that outputs corresponding to the input signal band $F_S$ in the output of the J-point FFT unit are multiplied by third order in-band distortion coefficients provided from the controller 280, by corresponding ones of the complex multiplication units 23C3. The third order distortion component upper band $F_{DU}$ and the third order distortion component lower band $F_{DL}$ are divided into M bands in total as depicted in Fig. 2 and bands (band $f_1$ to band $f_M$) obtained by the division are respectively multiplied by third order out-of-band distortion compensation coefficients which are provided from the controller 280 and correspond to respective bands.

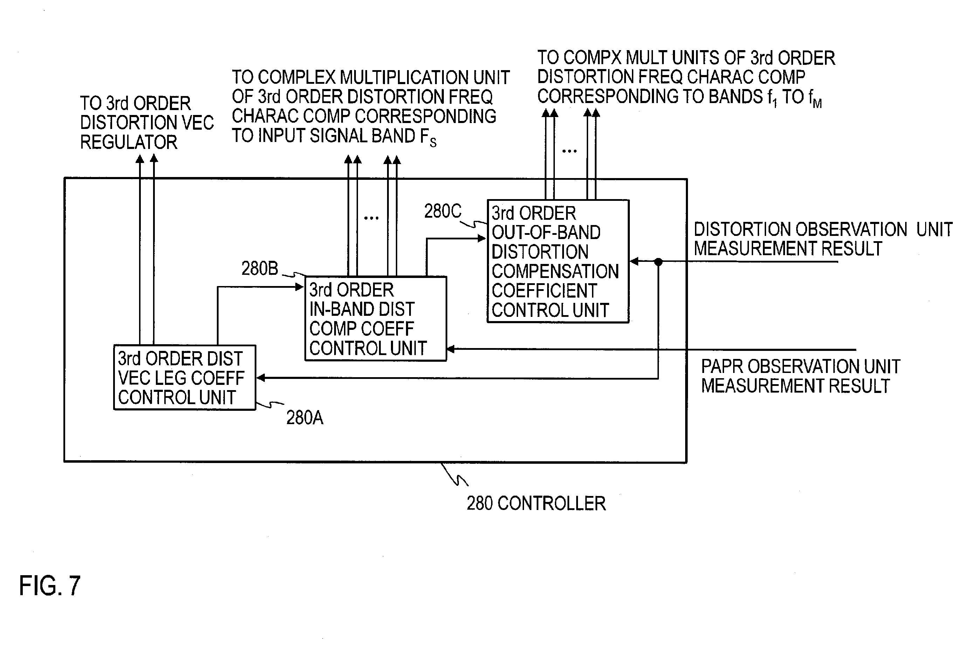

Fig. 7 illustrates the configuration of the controller 280 of the embodiment. The controller 280 is composed of a third order distortion vector regulator coefficient control unit 280A, a third order out-of-band distortion compensation coefficient control unit 280C, and a third order in-band distortion coefficient control unit 280B. The third order distortion vector regulator coefficient control unit 280A adjusts third order distortion vector regulator coefficients by using measurement results of the distortion observation unit 27 in the third order distortion component upper band $F_{DU}$ and the third order distortion component lower band $F_{DL}$ that are depicted in Fig. 2. The third order out-of-band distortion compensation coefficient control unit 280C adjusts third order out-of-band distortion compensation coefficients by using measurement results of the distortion observation unit 27 in respective divided bands $f_1$ to $f_M$. The third order in-band distortion coefficient control unit 280B adjusts third order in-band distortion coefficients by using measurement results of the PAPR observation unit 290.

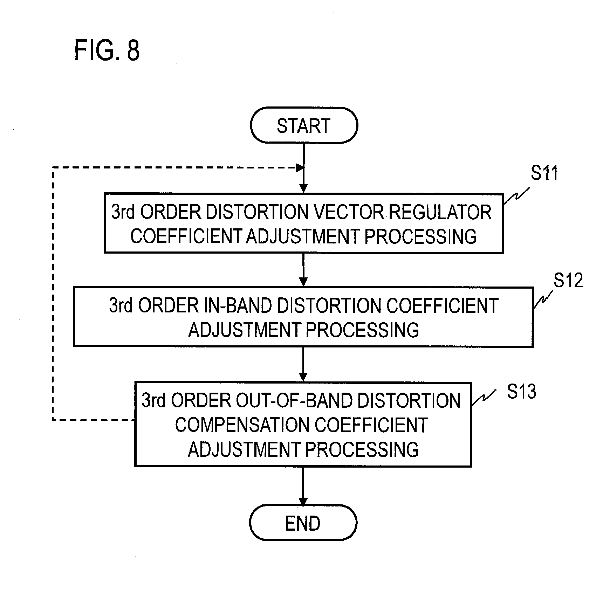

With respect to Fig. 8, description will be given of operations of the digital predistorter up to where power of distortion components (hereinafter, referred to as distortion component power, as well) is made minimum or equal to or less than a predetermined threshold value while reducing a PAPR in an output signal of the digital predistorter, that is, a flow of processing of the controller 280 will be described. Here, an input signal of the digital predistorter is assumed to be a predetermined pilot signal. The pilot signal may be a signal, which has predetermined arbitrary time length, for performing communication with a mobile station or a base station or a test signal which is defined by standards of a radio communication system (in a case of LTE (long term evolution), a signal of E-TM1.1), for example. A pilot signal is repeatedly inputted into the digital predistorter and processing S11, processing S12, and processing S 13 described later are repeated until distortion component power becomes to have a minimum value or to be equal to or less than a predetermined threshold value. After the distortion component power becomes equal to or less than the threshold value, the pilot signal is switched to a signal for performing communication with a mobile station or a base station. The third order distortion vector regulator coefficients and the third order out-of-band distortion compensation coefficients used here respectively have values which are obtained by making distortion component power obtained by the distortion observation unit 27 by using pilot signals minimum or equal to or less than a predetermined threshold value. In a case where a threshold value of distortion component power is set to be lower than the standards of the radio communication system in the adjustment of Fig. 8, a signal for performing communication with a mobile station or a base station may be used as substitute for the pilot signal as long as the distortion component power is in a range lower than the standards.

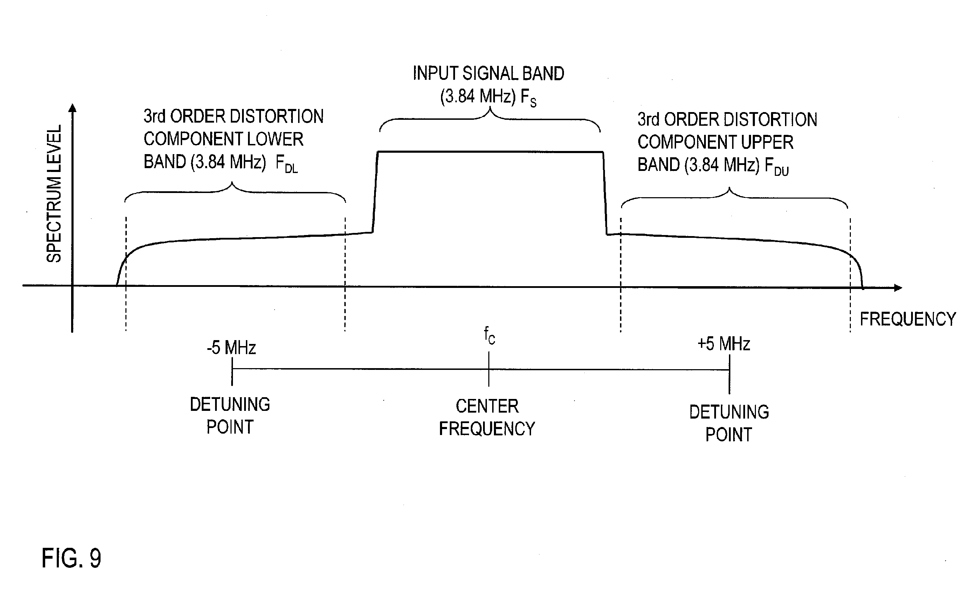

An example is illustrated in which ACLR (adjacent channel leakage power ratio) is used as a determination index of distortion compensation (that is, an index indicating a degree to which distortion component power generated by the power amplifier 33 is cancelled) in the third order distortion vector regulator coefficient adjustment processing S11 and the third order out-of-band distortion compensation coefficient adjustment processing S 13 for making distortion component power minimum or equal to or less than a threshold value. As depicted in Fig. 9, ACLRs here are set to a ratio $P_{DU}/P_S$ between in-band power $P_{DU}$ and power $P_S$ in the input signal band $F_S$ (a bandwidth is set to 3.84 MHz) and a ratio $P_{DL}/P_S$ between in-band power $P_{DL}$ and power $P_S$ in accordance with the measurement standard. $P_{DU}$ and $P_{DL}$ respectively denote in-band power of a third order distortion component upper band $F_{DU}$ and in-band power of a third order distortion component lower band $F_{DL}$ (respective bandwidths are set to 3.84 MHz) on $\pm 5$ MHz detuning points from a center frequency $f_C$, for example. The detuning point from the center frequency $f_C$ and the third order distortion component upper and lower bands $F_{DU}$ and $F_{DL}$ may be arbitrarily set in accordance with the bandwidth $F_S$ of the transmission signal $S_{IN}$. An ACLR is used as a determination index of distortion compensation in this embodiment, but power $P_{DU}$ and power $P_{DL}$ in respective third order distortion component upper and lower bands may be used as determination indexes.

The third order distortion vector regulator coefficient control unit 280A obtains and sets a phase value and an amplitude value respectively that are to be provided to the third order distortion vector regulator 23B in the third order distortion vector regulator coefficient adjustment processing (S11) described later. Subsequently, the third order distortion vector regulator coefficient control unit 280A notifies the third order in-band distortion coefficient control unit 280B of the phase value obtained by the third order distortion vector regulator coefficient adjustment processing. The third order in-band distortion coefficient control unit 280B calculates a phase value and an amplitude value respectively that are to be set in the third order in-band distortion coefficient adjustment processing (S12) described later by using the phase value which is notified and a measurement result of the PAPR observation unit 290, so as to respectively set a phase value and an amplitude value in the complex multiplication units 23C3, corresponding to the input signal band $F_S$, of the third order distortion frequency characteristic compensator 230C. Subsequently, the third order in-band distortion coefficient control unit 280B notifies the third order out-of-band distortion compensation coefficient control unit 280C of the end of the third order in-band distortion coefficient adjustment processing. Having received the notification, the third order out-of-band distortion compensation coefficient control unit 280C obtains and sets phase values and amplitude values respectively that are to be provided to the complex multiplication units 23C3, corresponding to bands $f_1$ to $f_M$, of the third order distortion frequency characteristic compensator 230C in the third order out-of-band distortion compensation coefficient adjustment processing (S 13) described later. When $ACLR_U$ and $ACLR_L$ of the upper band and the lower band are equal to or lower than the threshold value in the processing S13, the processing is ended. In a case where at least one does not become equal to or lower than the threshold value, the processing S11 to S 13 may be repeated as depicted by an arrow of a dashed line. Only the third order distortion frequency characteristic compensator 230C can compensate asymmetry distortion components, so that only the processing S 13 may be repeated when either one of the $ACLR_U$ and $ACLR_L$ of the upper band and the lower band does not become equal to or lower than the threshold value.

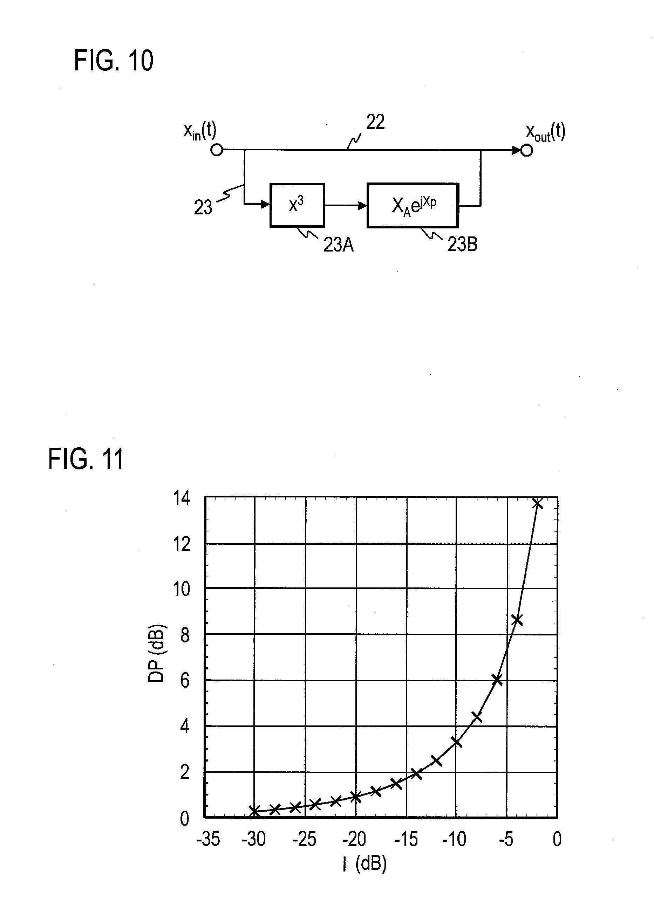

Principles of the present invention are described before the respective processing S11 to S 13 are described. Fig. 10 illustrates a simple model of the digital predistorter. This model is composed of the linear transmission path 22 and the third order distortion generation path 23, and the third order distortion generation path 23 includes the third order distortion generator 23A and the third order distortion vector regulator 23B.

An input signal $x_{in}(t)$ of the digital predistorter is set to $X_{in}(t)=s(t)e^{j\theta(t)}$, and a phase value and an amplitude value of the third order distortion vector regulator 23B are respectively set to $X_P$ $(-\pi \leq X_P \leq \pi)$ and $X_A$ $(0 < X_A)$. Here, an output signal $x_{out}(t)$ of the digital predistorter can be expressed by the following formula.

$$x_{out}(t)=s(t)e^{j\theta(t)}+|s(t)|^2 s(t)X_A e^{j(\theta(t)+Xp)} \quad (1)$$

The second term of the right side of Formula (1) denotes an output signal of the third order distortion generation path 23. That is, the third order distortion vector regulator 23B multiplies output of the third order distortion generator 23A by a complex coefficient $X_A e^{jXp}$. In the following description of this invention, setting an amplitude value $X_A$ and a phase value $X_P$ represents multiplying by the complex coefficient $X_A e^{jXp}$. This applies to setting of a phase value and an amplitude value by a complex multiplication unit in the third order distortion frequency characteristic compensator 23C described in Fig. 3 and the third order distortion frequency characteristic compensator 230C depicted in Fig. 6 described later. Denoting the time at which peak power Pout is generated in $x_{out}(t)$ in time t $(0 \leq t \leq T)$ by $t_1$, Pout can be expressed as below from Formula (1).

$$Pout=|x_{out}(t_1)|^2=|s(t_1)|^2(1+2|s(t_1)|^2 s(t_1)X_A cos(X_P)+|s(t_1)|^4 X_A^2) \quad (2)$$

Here, instantaneous power Pin of the input signal $x_{in}(t_1)$ is expressed as following.

$$Pin=|s(t_1)|^2 \quad (3)$$

Instantaneous power P3rd of an output signal in the third order distortion generation path 23 is expressed as the following.

$$P3rd=|s(t_1)|^6 X_A^2 \quad (4)$$

Here, when $\lambda=10log_{10}(P3rd/Pin)$ is set, $\Delta P$ that denotes a ratio between instantaneous power of $X_{in}(t_1)$ and peak power of $x_{out}(t_1)$ is expressed in logarithm as following.

$$\Delta P = 10\log_{10}|(Pin/Pout)|$$

$$= 10\log_{10}(1/(1+2|s(t_1)|^2 s(t_1)X_A\cos(X_P)+|s(t_1)|^4 X_A{}^2))$$

$$= 10\log_{10}(1/(1+2\times10^{(\lambda/20)}\cos(X_P)+10^{(\lambda/10)})) \qquad (5)$$

From Formula (5), it is understood that in a case where an amplitude value $X_A$ is set as a constant number, $\Delta P$ can be minimized when the phase value $X_P$ is set to $-\pi$ (or $\pi$). Thus, PAPR in an output signal of the digital predistorter can be reduced by making the phase of an output signal in the third order distortion generation path 23 reverse to an input signal of the digital predistorter. Fig. illustrates a calculation result of $\Delta P$ in a case where $X_P$ is set to $-\pi$ and $\lambda$ is changed. From Fig. 11, it is understood that $\Delta P$ is larger than 0 dB regardless of $\lambda$. That is, peak power Pout can be reduced to be lower than Pin. When Pout is desired to be reduced by $\Delta P_{red}$(dB) from Pin, $X_A$ can be uniquely obtained as following.

$$X_A = \sqrt{\frac{20\log_{10}\left(1-10^{-\frac{\Delta P_{red}}{20}}\right)}{|s(t_1)|^4}} \qquad (6)$$

Even if a phase value $X_P$ and an amplitude value $X_A$ which are obtained independently of distortion generated by the power amplifier 33 are set in the third order distortion vector regulator 23B in order to reduce PAPR as described above, output signals of the third order distortion generation path 23 may not become components to cancel distortion components generated by the power amplifier 33. In such a case, third order distortion components in an upper band and a lower band cannot be compensated for. Therefore, a phase value and an amplitude value of an input signal band are respectively adjusted in a frequency domain by using the third order distortion frequency characteristic compensator 230C so as to reduce PAPR in this invention. Accordingly, it becomes possible to reduce PAPR while compensating for third order distortion components in the upper band and the lower band.

[Third Order Distortion Vector Regulator Coefficient Adjustment Processing (S11)]

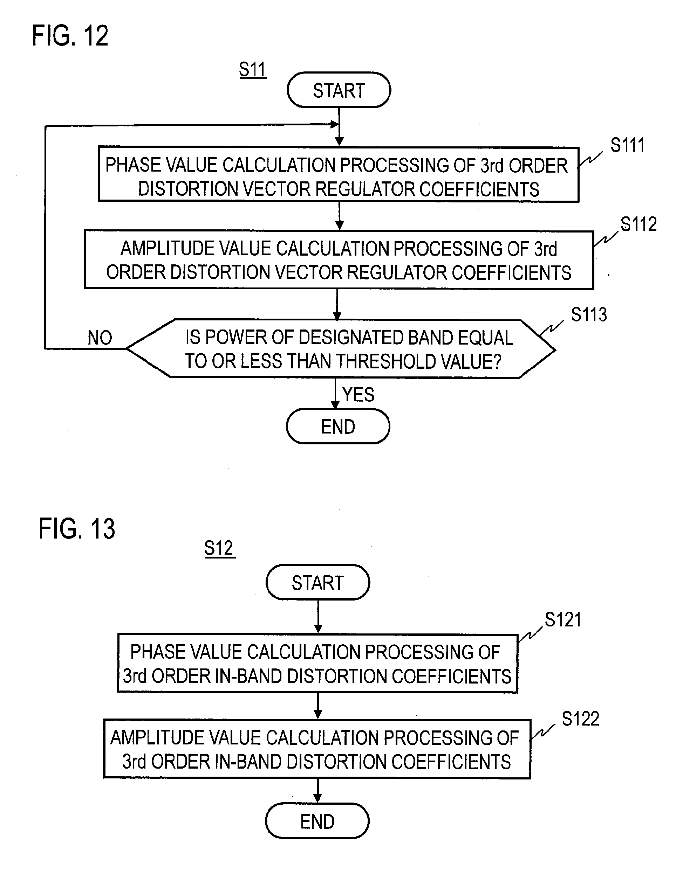

Fig. 12 illustrates a flow of the third order distortion vector regulator coefficient adjustment processing S11 performed by the third order distortion vector regulator coefficient control unit 280A. In Fig. 12, processing is performed in the order of phase value calculation processing (S111) of third order distortion vector regulator coefficients and amplitude value calculation processing (S112) of third order distortion vector regulator coefficients. At this time, one band (referred to as a designated band) is preliminarily selected from the third order distortion upper band $F_{DU}$ and the third order distortion lower band $F_{DL}$ and whether power (distortion component power) $P_D$ ($P_{DU}$ or $P_{DL}$) of the designated band is equal to or lower than a threshold value or has the minimum value is determined (S113). The processing S111 to the processing S113 are repeated until the power of the designated band becomes to be equal to or lower than the threshold value or to have the minimum value.

The phase value calculation processing S111 of third order distortion vector regulator coefficients and the amplitude value calculation processing S112 of third order distortion vector regulator coefficients employ a perturbation method (refer to reference literature 1) or a calculation method using quadratic function approximation (refer to reference literature 2), for example.

In the phase value calculation processing S111 of third order distortion vector regulator coefficients employing the perturbation method, power $P_D$ of designated bands before and after a phase value $X_P$ which is primarily arbitrarily set is measured and a phase value is changed by an offset value $\Delta X_P$, which is preliminarily set, in a direction in which the power $P_D$ of the designated band is decreased, so as to measure the power $P_D$ of the designated band by the distortion observation unit 27. The change in the phase value and the measurement of power of the designated band are repeated so as to obtain a phase value $X_{P,MIN}$ at which the power $P_D$ of the designated band becomes to be equal to or less than a threshold value or to have the minimum value. The obtained phase value $X_{P,MiN}$ is set to the third order distortion vector regulator 23B. The same description is applicable to an amplitude value. Here, an obtained amplitude value is denoted as $X_{A,MIN}$.

In the phase value calculation processing S111 of third order distortion vector regulator coefficients employing the quadratic function approximation method, power ($P_{D,1}$, $P_{D,2}$, ..., $P_{D,K}$) of respective designated bands are measured at phase values ($X_{P,1}$, $X_{P,2}$, ..., $X_{P,K}$) of different K points (K is an integer equal to or larger than 3) and coefficients ($a_2$, $a_1$, $a_0$) of a quadratic function ($P_D=a_2X_P^2+a_1X_P+a_0$) indicating dependency of power in a designated band with respect to a phase value are obtained by a method of least squares from the used phase values ($X_{P,1}$, $X_{P,2}$, ..., $X_{P,K}$) and the measured power ($P_{D,1}$, $P_{D,2}$, ..., $P_{D,K}$) of the designated bands. A phase value $X_{P,MIN}(=-a1/2a_2)$ at which the power $P_D$ of the designated band becomes minimum at the obtained coefficients ($a_2$, $a_1$, $a_0$) is set in the third order distortion vector regulator 23B. The same description is applicable to an amplitude value. In the phase value calculation processing S111 of third order distortion vector regulator coefficients, coefficients ($b_2$, $b_1$, $b_0$) of a trigonometric function ($P_D=b_2\cos(b_1-X_P)+b_0$) may be obtained as substitute for coefficients of a quadratic function as dependency of power in a designated band with respect to a phase value. The obtained phase value $X_P$ at which the power $P_D$ of the designated band becomes minimum (that is, $b_1-X_P=\pi$) in the trigonometric function is set as a phase value $X_{P,MIN}(=b_1-\pi)$ of the third order distortion vector regulator 23B.

In the calculation method employing the quadratic function approximation, when a coefficient $a_2$ becomes 0 or less or a coefficient of the quadratic function is not obtained, a phase value at which power of a designated band becomes lowest among measured power of designated bands may be set as $X_{P,MIN}$.

In this example, the phase value calculation processing S111 of third order distortion vector regulator coefficients and the amplitude value calculation processing S 112 of third order distortion vector regulator coefficients are performed in this order. This is because an increase/decrease in power $P_D$ in a designated band with respect to a phase value is commonly higher than an increase/decrease in power in a designated band with respect to an amplitude value. However, there is a case where the increase/decrease in power $P_D$ in a designated band with respect to an amplitude value is higher than that to a phase value, depending on a property of the power amplifier 33. In such a case, the amplitude value calculation processing S112 of third order distortion vector regulator coefficients and the phase value calculation processing S111 of third order distortion vector regulator coefficients may be performed in this order.

In this example, when the power $P_D$ of the designated band does not become equal to or less than a threshold value or reach the minimum value, the processing S11 does not end. Therefore, it may be set such that the processing S11 ends when the phase value calculation processing S111 of the third order distortion vector regulator coefficients and the amplitude value calculation processing S112 of the third order distortion vector regulator coefficients are repeated predetermined number of times. At this time, a phase value and an amplitude value at which power $P_D$ of a designated band becomes minimum among phase values and amplitude values that are obtained by the processing S11 are set in the third order distortion vector regulator. In order to perform this processing, it is assumed that a phase value and an amplitude value at which power $P_D$ of a designated band becomes lowest among set phase values and amplitude values are respectively stored in a storage means, which is not depicted, in a manner to be associated with power $P_D$.

Reference literature 1: T. Nojima and T. Konno, "Cuber Predistortion Linearizer for Relay Equipment in 800 MHz Band Land Mobile Telephone System," IEEE Transactions on vehicular technology, Vol. 34, Issue 4, pp. 169-177, 1985.

Reference literature 2: J. Ohkawara, Y. Suzuki, and S. Narahashi, "Fast Calculation Scheme for Frequency Characteristic Compensator of Digital Predistortion Linearizer," IEEE Vehicular Technology Conference Spring 2009, proceedings, Apr. 2009.

[Third Order In-Band Distortion Coefficient Adjustment Processing (S12)]

Fig. 13 illustrates a flow of third order in-band distortion coefficient adjustment processing S12 performed by the third order in-band distortion coefficient control unit 280B. The third order in-band distortion coefficient control unit 280B receives a notification of a phase value $X_{P,MIN}$ set in the third order distortion vector regulator from the third order distortion vector regulator coefficient control unit 280A. When $PAPR_{OUT}$, which is measured by the PAPR observation unit 290, in the output signal of the combiner 24 is higher than a threshold value ($PAPR_{TH}$) of PAPR, a phase value $Y_P$ ($=\pi-X_{P,MIN}$) to be provided to the complex multiplication units 23C3, which corresponds to an input signal band, of the third order distortion frequency characteristic compensator 230C is calculated on the basis of the principle described in Fig. 10 so as to be set (S121). Subsequently, an amplitude value at which a PAPR in an output signal of the combiner 24 becomes equal to or less than a threshold value is calculated and set by the amplitude value calculation processing of the third order in-band distortion coefficients (S122). Specifically, a difference $\Delta PAPR$ ($=PAPR_{IN}-PAPR_{TH}$) (dB) between a PAPR (referred to as a $PAPR_{IN}$), which is measured by the PAPR observation unit 290, in an input signal of the digital predistorter 200 and a predetermined threshold value $PAPR_{TH}$ is obtained. Then, based on Formula (6), an amplitude value $Y_A$ to be provided to the complex multiplication units 23C3, which correspond to an input signal band $F_S$, of the third order distortion frequency characteristic compensator 230C is calculated by the following Formula (7) so as to be set.
$$Y_A = \sqrt{\frac{20\log_{10}\left(1 - 10^{-\frac{\Delta PAPR}{20}}\right)}{\left|s(t_1)\right|^4}} \qquad (7)$$

Here, $\left|s(t_1)\right|^4$ is a squared instantaneous power value of an input signal at time $t_1$ at which peak power of combiner output is generated and is observed and calculated by the PAPR observation unit 290.

After the amplitude value $Y_A$ is set in the processing S122, the third order in-band distortion coefficient control unit 280B notifies the third order out-of-band distortion compensation coefficient control unit 280C of the end of the processing S12. When $PAPR_{OUT}$ is observed after the execution of the processing S121 and the $PAPR_{OUT}$ is lower than $PAPR_{TH}$, the processing S12 may be ended without performing the processing S122.

In this embodiment, PAPR of an output signal of the digital predistorter can be reduced without repeatedly performing the processing S121 and S122 in the processing S12, so that an amount of calculations related to PAPR reduction can be reduced compared to the configuration employing PAPR reduction apparatus of the related art.

[Third Order Out-Of-Band Distortion Compensation Coefficient Adjustment Processing (S 13)]

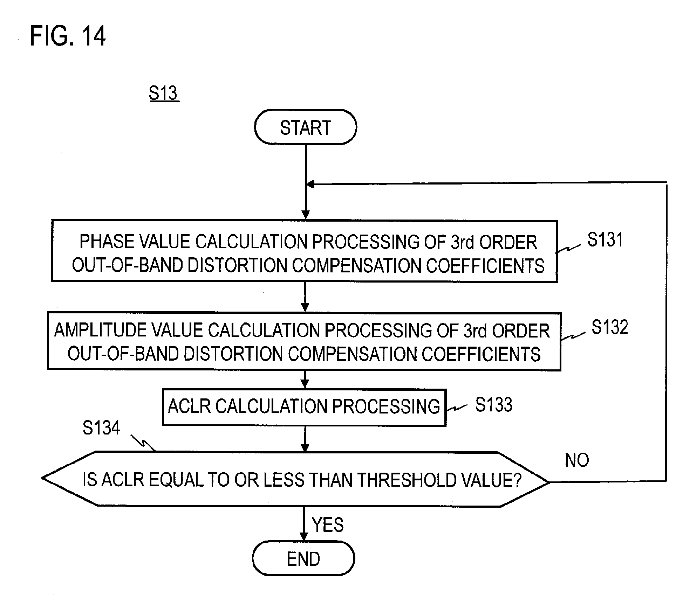

Fig. 14 illustrates a flow of the third order out-of-band distortion compensation coefficient adjustment processing S13 performed by the third order out-of-band distortion compensation coefficient control unit 280C. As described in Fig. 2, the third order out-of-band distortion compensation coefficient control unit 280C performs the phase value calculation processing S131 of the third order out-of-band distortion compensation coefficients and the amplitude value calculation processing S132 of the third order out-of-band distortion compensation coefficients for each of the divided bands $f_m$ (m=1, ..., M) in accordance with a predetermined order. Subsequently, when ACLR calculation processing (S133) is performed and if it is determined in the processing S134 that both of ACLRs (namely, an $ACLR_U$ and an $ACLR_L$) of the upper band $F_{DU}$ and the lower band $F_{DU}$ are equal to or less than the threshold value, the third order out-of-band distortion compensation coefficient adjustment processing S 13 is ended without calculating third order out-of-band distortion compensation coefficients in the rest of the divided bands to leave them in their initial values. Further, when either one of the ACLR of the upper band or the ACLR of the lower band is not equal to or less than the threshold value in processing S 134, the processing is returned to the processing S131 and the phase value calculation processing S131 of the third order out-of-band distortion compensation coefficients and the amplitude value calculation processing S132 of the third order out-of-band distortion compensation coefficients are performed in this order for the rest of divided bands. When the ACLR does not become equal to or less than the threshold value even though the processing of all of the divided bands is finished in the processing S 134, the processing may be returned to the processing S as depicted by an arrow of a dashed line in Fig. 8 and the processing S11, S12, and S 13 may be performed again. Regarding the processing order of the divided bands, processing may be alternately performed in the upper bands and the lower bands. Alternatively, one band is selected from each of the upper bands and the lower bands and the processing may be performed for every pair of the selected bands, for example.

In the phase value calculation processing S131 of the third order out-of-band distortion compensation coefficients in the divided band $f_m$ ($1 \leq m \leq M$), a phase value $Z_{P,m}$ to be set in the complex multiplication unit 23C3, which corresponds to the divided band $f_m$, of the third order distortion frequency characteristic compensator 230C is obtained by using the perturbation method or the calculation method using quadratic function approximation as is the case with the phase value calculation processing S111 (Fig. 12) of the third order distortion vector regulator coefficients, so as to be set. Though distortion component power $P_D$ ($P_{DU}$ or $P_{DL}$) of the upper or lower designated band is measured by the distortion observation unit 27 in the phase value calculation processing S111 of the third order distortion vector regulator coefficients as described above, power $D_{Dm}$ in the divided band $f_m$ for setting a phase value is measured so as to determine the minimum phase value $Z_{P,m}$, in the phase value calculation of the third order out-of-band distortion compensation coefficients. The same description is applicable to the amplitude value calculation processing S 132 of a third order out-of-band distortion compensation coefficient.

In this example, the phase value calculation processing S 131 (or the amplitude value calculation processing S132) of the third order out-of-band distortion compensation coefficients is performed sequentially for every band or every two bands of the divided bands. However, the phase value calculation processing S131 of the third order out-of-band distortion compensation coefficients or the amplitude value calculation processing S 132 of the third order out-of-band distortion compensation coefficients may be performed in three or more divided bands (for example, all divided bands except for an input signal band) simultaneously. Further, the order of the phase value calculation processing S131 of the third order out-of-band distortion compensation coefficients and the order of the amplitude value calculation processing S132 of the third order out-of-band distortion compensation coefficients may be switched depending on the property of the power amplifier 33 as is the case with the third order distortion vector regulator coefficient adjustment processing.

Since a phase value and an amplitude value are respectively adjusted for every divided band in the third order out-of-band distortion compensation coefficient adjustment processing S13 of Fig. 14, it can be considered that an increase amount of PAPR is small compared to the third order distortion vector regulator coefficient adjustment processing S of Fig. 12. Therefore, it can be considered that increase of $PAPR_{OUT}$ by the processing S 13 can be ignored. However, when $PAPR_{OUT}$ exceeds $PAPR_{TH}$ by the processing S 13, the third order in-band distortion coefficient adjustment processing S12 of Fig. 13 may be performed again. When both of the $ACLR_U$ and the $ACLR_L$ are equal to or less than the threshold value after the processing S12 is performed again, the processing S 13 does not have to be performed. The same applies to other embodiments.

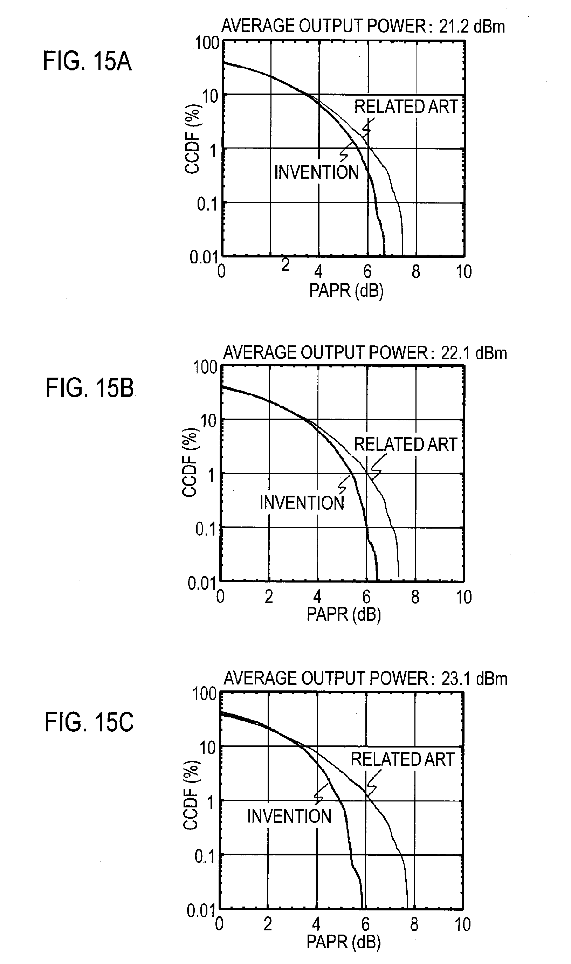

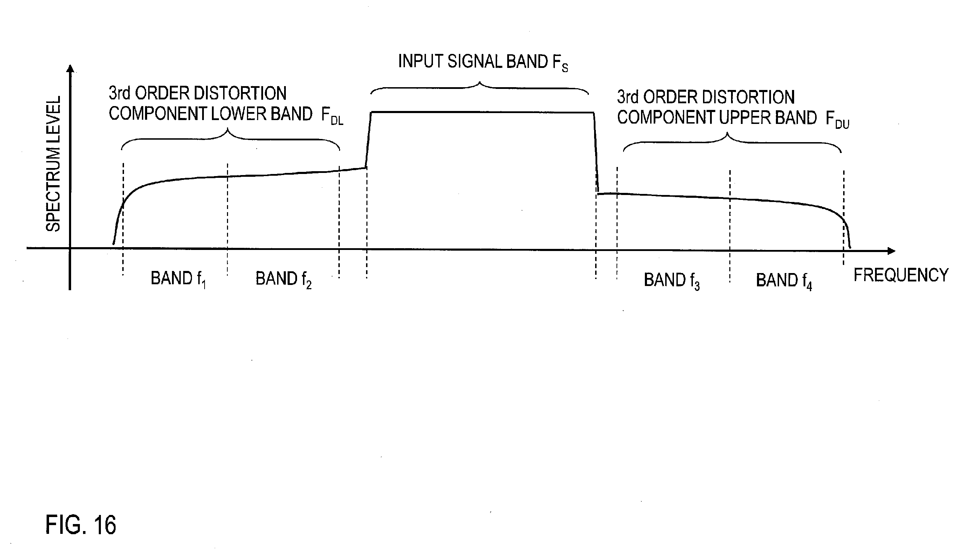

Examples of experimental results in the embodiment of Fig. 5 are shown by thick lines in Figs. 15A, 15B, and 15C. Results of the conventional configuration of Fig. 1 are shown by thin lines for reference. A vertical axis represents CCDF and a horizontal axis represents PAPR in predistorter output. In the experiment, a center frequency of a power amplifier input signal was set to 21.4 GHz and a 2 GHz band 1 W class power amplifier (AB class bias) was used. Figs. 15A, 15B, and 15C respectively show cases where average output power of the power amplifier 33 are 21.2 dBm, 22.1 dBm, and 23.1 dBm. Fig. 16 illustrates division of a frequency band by the third order distortion frequency characteristic compensator 230C. In order to compensate for distortion components of the third order distortion component upper band $F_{DU}$ and lower band $F_{DL}$, M=4 was set and each of the upper band and the lower band was divided by two at even intervals. In addition, phases and amplitudes of the third order distortion components in the input signal band $F_S$ are adjusted so as to reduce PAPR. In this experiment, the amplitude value calculation processing S122 of the third order in-band distortion coefficients was not performed in the third order in-band distortion coefficient adjustment processing S12. When PAPRs at which CCDF is 0.1% are compared to each other, it can be understood that a PAPR can be reduced from 7.2 dB to 6.3 dB in Fig. 15A, from 7.1 dB to 6.0 dB in Fig. 15B, and from 7.4 dB to 5.4 dB in Fig. 15C.

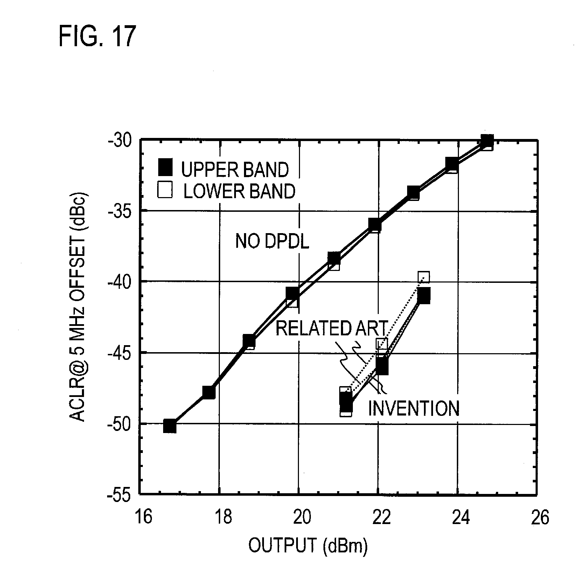

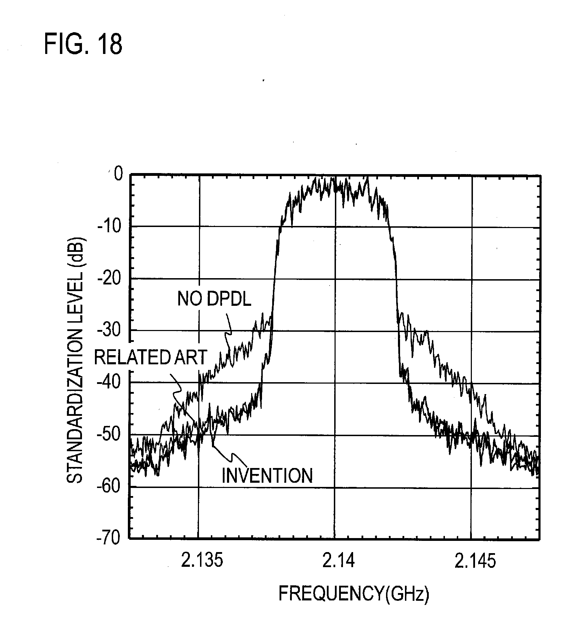

Fig. 17 illustrates a result of ACLR to average output power according to the embodiment of Fig. 5 by solid lines and a result related to the conventional configuration of Fig. 1 by dashed lines. The vertical axis represents ACLR and the horizontal axis represents average power in an amplifier output. From the results, it can be understood that the ACLR is slightly improved in the same average output power by using the present embodiment compared to the example of related art. Here, a case where digital predistortion is not performed is also depicted in the drawing as no DPDL (digital predistortion linearizer). Fig. 18 illustrates output spectra of the power amplifier at average output power of 22.1 dB in a case of this invention, a case of the conventional configuration, and a case where predistortion is not performed, as reference. From this result as well, it is understood that distortion components are lowered by this embodiment.

In the embodiment of Fig. 5, the configuration in which N=3 and only the third order distortion generation path is provided is described. However, such a configuration may be employed in which one or a plurality of distortion generation paths of different odd orders which are higher than third order may be further provided in parallel with the third order distortion generation path. This configuration is applicable to other embodiments. For example, when there are a third order distortion generation path and a fifth order distortion generation path, respective coefficients which are third order distortion vector regulator coefficients, third order in-band distortion coefficients of the third order distortion generation path, fifth order distortion vector regulator coefficients, fifth order in-band distortion coefficients of the fifth order distortion generation path, third order out-of-band distortion compensation coefficients, and fifth order out-of-band distortion compensation coefficients are obtained in this order.

There is a case where average power in an output signal of the digital predistorter 200 is decreased when the third order in-band distortion coefficient adjustment processing S12 is performed in the embodiment of Fig. 5. Therefore, an automatic gain adjuster (AGC) which is not depicted may be disposed between the combiner 24 and the power amplifier 33 or at an input side of the divider 21 and gains of the AGC may be adjusted by the controller 280 so as to obtain same average power before and after the execution of the processing S12. At this time, average power may be measured by the PAPR observation unit 290 so as to be notified to the controller 280, and a function to measure average power of output of the power amplifier 33 may be added to the distortion observation unit 27 so as to notify the controller 280 of an observation result of average power. The controller 280 preliminarily stores average power which is to be inputted into the power amplifier 33 in a storage means which is not depicted and adjusts a gain of the AGC so as to decrease difference between the average power and notified average power. The configuration employing the AGC may be applied to the following embodiments.

A signal inputted into the power amplifier 33 changes when phase values and amplitude values of the third order distortion frequency characteristic compensator 230C corresponding to the input signal band $F_S$ are adjusted, so that there is a case where distortion components vary due to nonlinearity of the power amplifier. Therefore, there is a possibility that the number of repetitions until ACLR equal to or less than the threshold value is obtained is increased when the orders of the processing S12 and the processing S 13 are switched in Fig. 8, so that it is desirable that the processing is performed in the order depicted in Fig. 8.

Commonly, the characteristics of the power amplifier do not largely fluctuate unless external environment of the power amplifier such as a temperature, average power of the power amplifier input signal, and the like are rapidly changed. Therefore, when a pilot signal is switched to a signal for performing communication with a mobile station or a base station, an amplitude value and a phase value for the third order distortion vector regulator coefficients, amplitude values and phase values for the third order out-of-band distortion compensation coefficients, and a phase value for the third order in-band distortion coefficients are kept as values respectively obtained by using pilot signals unless ACLR exceeds the threshold value and an amplitude value for the third order in-band distortion compensation coefficients is reset depending on the $PAPR_{IN}$ by the processing S122. When the $PAPR_{IN}$ does not largely change, an amplitude value for the third order in-band distortion compensation coefficients does not have to be adaptively set in accordance with a transmission signal but may be kept as a value obtained by using a pilot signal.

In order to handle the case where the characteristics of the power amplifier change due to the average power fluctuation of an input signal to the power amplifier 33, a look-up table (LUT), which is not depicted, in the controller 280 in which third order distortion vector regulator coefficients, third order out-of-band distortion compensation coefficients, and third order in-band distortion coefficients to be set in accordance with average power or instantaneous power of an input signal in the digital predistorter are respectively stored may be referred and the third order distortion vector regulator coefficients, the third order out-of-band distortion compensation coefficients, and the third order in-band distortion coefficients may be respectively provided to the third order distortion vector regulator 23B and the third order distortion frequency characteristic compensator 230C. The third order distortion vector regulator coefficients, the third order out-of-band distortion compensation coefficients, and the third order in-band distortion coefficients which are stored in the LUT are preliminarily calculated respectively by using the method mentioned in this embodiment. The configuration employing the LUT may be applied to other embodiments.

The PAPR observation unit 290 observes each of output of the divider 21 and output of the combiner 24, but may observe output of the third order distortion frequency characteristic compensator 230C instead of output of the combiner 24. At this time, the PAPR observation unit 290 adds output of the divider 21 and output of the third order distortion frequency characteristic compensator 230C so as to calculate peak power and average power in output of the combiner 24 respectively. This configuration may be applied to other embodiments.

The feedback signal generating apparatus 40 may be configured to input a signal down-converted into an IF band into the ADC 26 without using the quadrature demodulator 43, for example. At this time, there is a case where a sampling rate of the ADC 26 can be reduced and power consumption of the ADC 26 can be reduced. This provides low power consumption of the digital predistorter 200.

In order to measure power of an input signal band $F_S$ from the signal down-converted into the IF band, an analog band-pass filter which allows to pass through only the band $F_S$ and a power detector may be prepared to be used as substitute for the distortion observation unit 27. In a similar manner, M band-pass filters, which allow passing through only the respective bands $f_m$, and power detectors are prepared so as to measure power of respective divided bands, and used as substitute for the distortion observation unit 27. At this time, each of output of the power detector is inputted into the controller 280 through the ADC 26. Accordingly, there is a case where an amount of calculations related to distortion component power by the digital signal processing can be reduced.

When the above-mentioned configuration is applicable, the configuration may be applied to other embodiments as necessary.

[Second Embodiment]

There is a possibility that a PAPR of an output signal of the digital predistorter does not become equal to or less than a threshold value depending on a property of an input signal of the digital predistorter, in the configuration illustrated in the first embodiment of Fig. 5. Therefore, the third order in-band distortion coefficients (a phase value and an amplitude value) are repeatedly adjusted until PAPR of an output signal of the digital predistorter becomes equal to or less than the threshold value in a second embodiment.

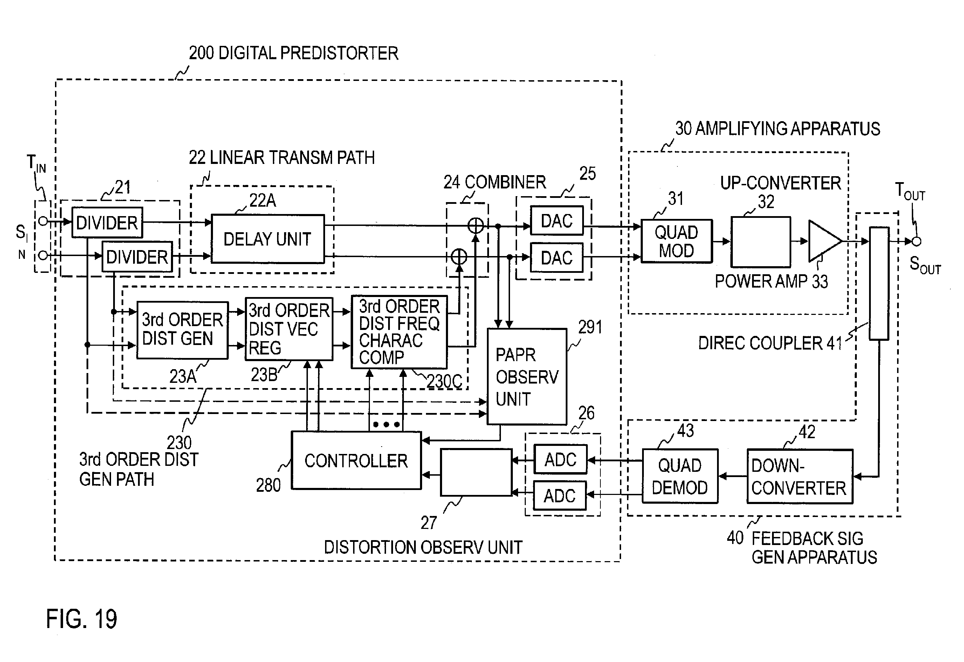

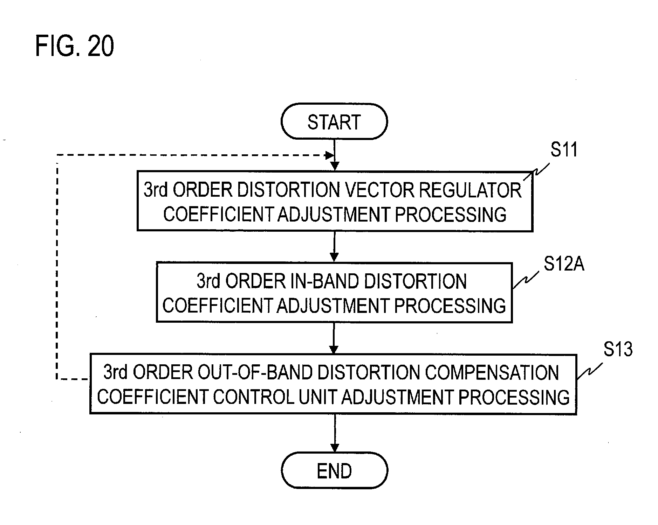

Fig. 19 illustrates a configuration example of the second embodiment of the present invention. Points different from the first embodiment are a PAPR observation unit 291 and processing of the controller 280. The configuration of the controller 280 itself is the same as that of the controller 280 depicted in Fig. 7, so that Fig. 7 is referred. The PAPR observation unit 291 observes only PAPR of output of the combiner 24. Fig. 20 illustrates a flow of the processing of the controller 280. In this processing flow, third order in-band distortion coefficient adjustment processing (S12A) performed by the third order in-band distortion coefficient control unit 280B (refer to Fig. 7) is different from the processing S12 in Fig. 8 in the first embodiment.

Processing of the processing S12A of the third order in-band distortion coefficient control unit 280B is described. Other processing is the same as that of Fig. 8, so that the description thereof is omitted. It is assumed that while the processing flow of the controller 280 depicted in Fig. 20 is performed, a pilot signal is inputted as an input signal $S_{IN}$ of the digital predistorter as is the case with the first embodiment. After the processing flow of the controller 280 is ended, switching into a signal for performing communication with a mobile station or a base station is performed as is the case in the first embodiment.

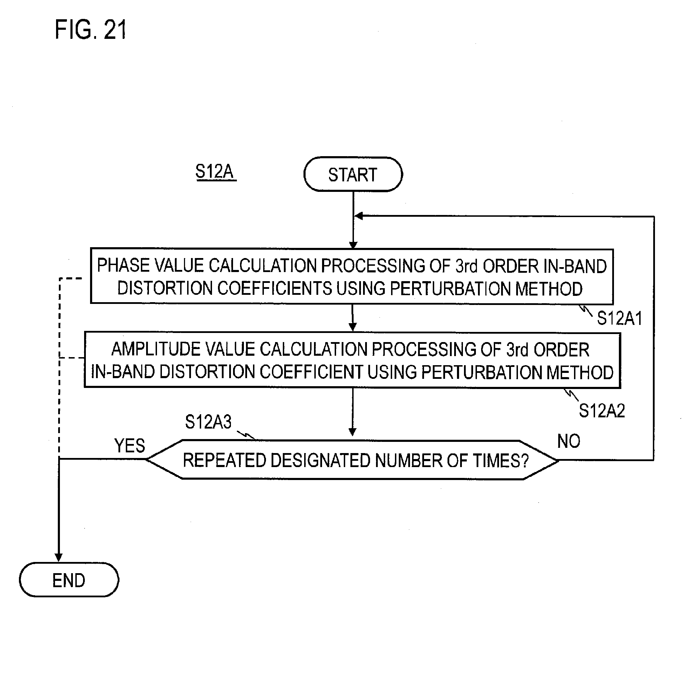

Fig. 21 illustrates a flow of the third order in-band distortion coefficient adjustment processing S12A performed by the third order in-band distortion coefficient control unit 280B.

[Third Order In-Band Distortion Coefficient Adjustment Processing (S12A)]

The third order in-band distortion coefficient control unit 280B receives notification of a phase value $X_{P,MIN}$ which is set in the third order distortion vector regulator 23B from the third order distortion vector regulator coefficient control unit 280A. Subsequently, phase value calculation processing (S12A1) of the third order in-band distortion coefficients employing the perturbation method is performed. That is, in the processing S12A1, after a phase value $Y_P$ ($=\pi-X_{P,MIN}$) is calculated so as to be set as an initial value in the complex multiplication unit 23C3 (refer to Fig. 6) corresponding to an input signal band of the third order distortion frequency characteristic compensator 230C, PAPR in the output signal of the digital predistorter 200 is measured before and after $Y_P$ by the PAPR observation unit 291 and the phase value is changed by a predetermined offset value $\Delta Y_P$ in a direction in which the PAPR is decreased, and PAPR is measured, again. Here, as an initial value of the perturbation method, a phase value $Y_P=\pi-X_{P,MIN}$ which is determined in the third order distortion vector regulator coefficient adjustment processing S is not used but an arbitrary value may be used as an initial value. The phase value $Y_{P,MIN}$ at which PAPR becomes minimum is stored and updated in a storage means, which is not depicted, by repeating the change of a phase value and the measurement of PAPR. When the phase value $Y_{P,MIN}$ at which PAPR becomes equal to or less than the threshold value is determined, or when PAPR does not become equal to or less than the threshold value even after the designated number of repetitions, amplitude value calculation processing (S12A2) of the third order in-band distortion coefficients employing the perturbation method is performed. A phase value at this time is set to a value at which PAPR is the lowest in the processing S12A1. In order to perform this processing, it is assumed that when PAPR which is obtained every time a phase value is calculated and set in the processing S12A1 is smaller than the stored minimum PAPR, the minimum PAPR is updated and the phase value at the time is stored as the phase value $Y_{P,MIN}$ at which PAPR is the lowest.

In the processing S12A2, PAPR of combiner output is measured by the PAPR observation unit 291 before and after the amplitude value $Y_A$ which is arbitrarily set at first, and an amplitude value is changed by a predetermined offset value $\Delta Y_A$ in a direction in which PAPR is decreased, and PAPR is measured, again, as is the case with the processing S12A1. The amplitude value $Y_{A,MIN}$ at which PAPR becomes minimum is stored and updated by repeating the change of an amplitude value and the measurement of PAPR, so as to obtain the amplitude value $Y_{A,MIN}$ at which PAPR becomes equal to or less than the threshold value. When PAPR does not become equal to or less than the threshold value in the processing S12A2, one of the set amplitude values at which PAPR becomes minimum is set. In order to perform this processing, an amplitude value is calculated in the processing S12A2, the minimum PAPR is updated when PAPR obtained at every setting is lower than the stored minimum PAPR and the amplitude value is stored as an amplitude value $Y_{A,MIN}$ at which PAPR is the lowest. The processing S12A1 and the processing S12A2 are repeated designated number of times (S12A3). In the case of the repetition, the phase value $Y_P$ which is first set in the processing S12A1 is stored as $Y_{P,MIN}$ and the amplitude value $Y_A$ which is first set in the processing S12A2 is stored as $Y_{A,MIN}$. At this time, $\Delta Yp$ and $\Delta Y_A$ may be respectively changed.

When PAPR becomes equal to or less than the threshold value in either processing S12A1 or processing S12A2, the processing S12A is ended and the processing is shifted to the processing of the processing S13 of Fig. 20 (a dashed line of Fig. 21). When PAPR does not become equal to or less than the threshold value even if the processing S12A1 and the processing S12A2 are repeated designated number of times, a phase value and an amplitude value among the set phase values and amplitude values at which PAPR becomes the lowest may be respectively set in the complex multiplication unit 23C3 corresponding to an input signal band of the third order distortion frequency characteristic compensator 230C, and the processing may be shifted to the processing S 13.

In the present embodiment, after the processing S12A1 is performed, processing which does not employ the perturbation method of the processing S12A2 but employs calculation using Formula (7) may be performed, as is the case with the processing S122 of Fig. 13. In this case, it is set that a split input signal is provided to the PAPR observation unit 291 as depicted by a dashed line in Fig. 19 so as to make it possible to measure $PAPR_{IN}$. Further, instead of the perturbation method of the processing S12A1, the processing S12A2 may be performed after processing by calculation of $Y_P=\pi-X_{P,MIN}$ is performed as is the case in the processing S121 of Fig. 13. At this time, only the processing S12A2 is repeated in the processing S123.

When switching to a signal for performing communication with a mobile station or a base station is performed, values which are obtained by using pilot signals are continuously used as an amplitude value and a phase value of the third order distortion vector regulator coefficients, a phase value and an amplitude value of the third order in-band distortion coefficients, and amplitude values and phase values of the third order out-of-band distortion compensation coefficients until ACLR exceeds the threshold value again.

[Modification]

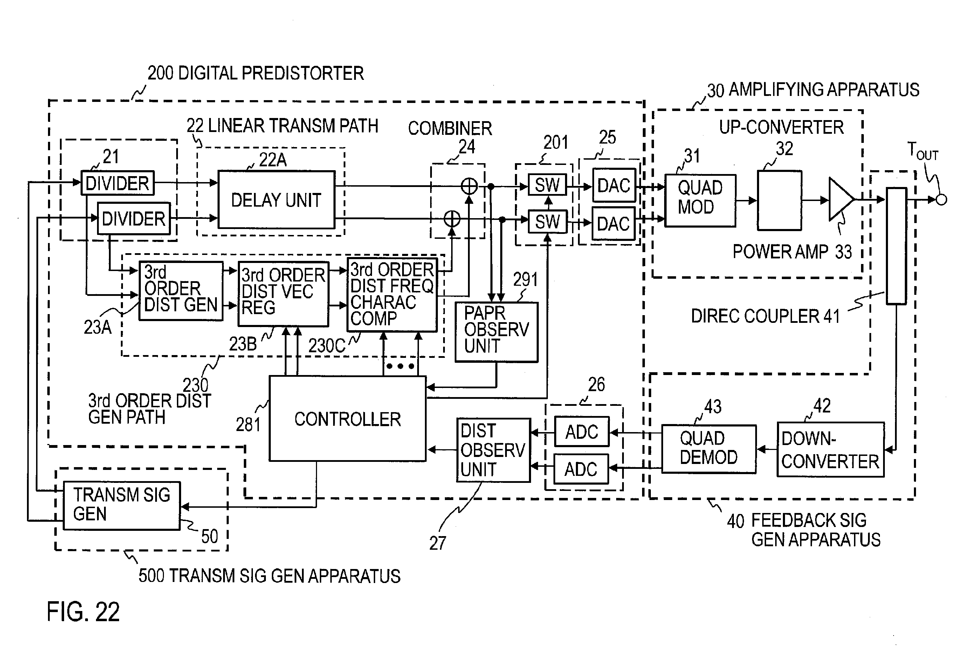

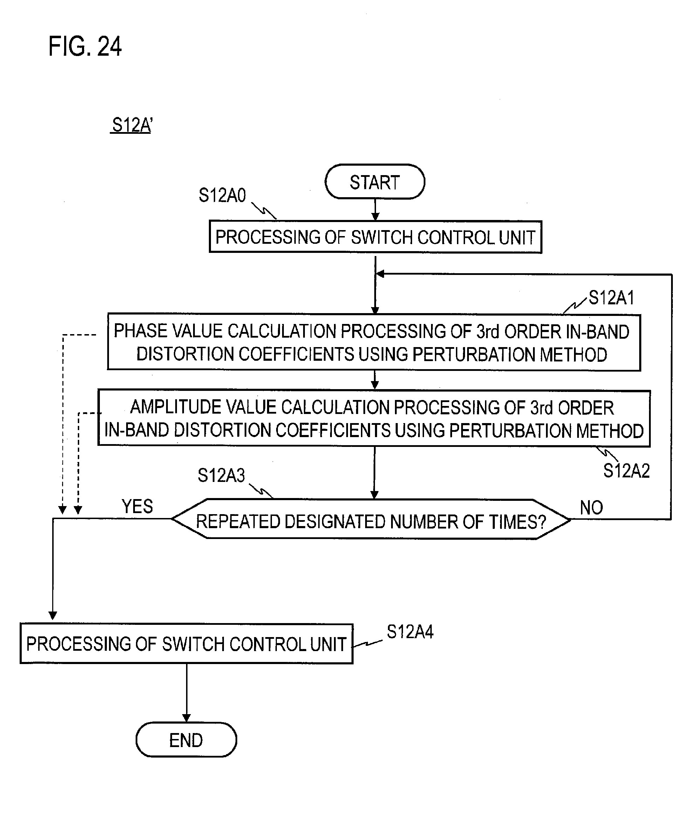

In a modification of Fig. 22, when a PAPR$_{OUT}$ in output of the combiner 24 exceeds the threshold value after the setting processing using a pilot signal is ended in the second embodiment of Fig. 19 and the input signal is switched from the pilot signal to a signal for performing communication with a mobile station or a base station, an amplitude value and a phase value of the third order distortion vector regulator coefficients and amplitude values and phase value of the third order out-of-band distortion compensation coefficients may be kept as values obtained by using the pilot signal respectively, and only a phase value and an amplitude value of the third order in-band distortion coefficients may be adjusted by third order in-band distortion coefficient adjustment processing (S12A') of Fig. 24 described later. During the performance of the processing S12A', a transmission signal of a predetermined length including a portion in which PAPR$_{OUT}$ exceeds the threshold value is repeatedly used. When ACLR exceeds the threshold value even though PAPR$_{OUT}$ becomes equal to or less than the threshold value by the processing S12A', the transmission signal of the predetermined length is repeatedly used by the method described in the embodiment of Fig. 19 so as to respectively readjust an amplitude value and a phase value of the third order distortion vector regulator coefficients, a phase value and an amplitude value of the third order in-band distortion coefficients, and amplitude values and phase values of the third order out-of-band distortion compensation coefficients.

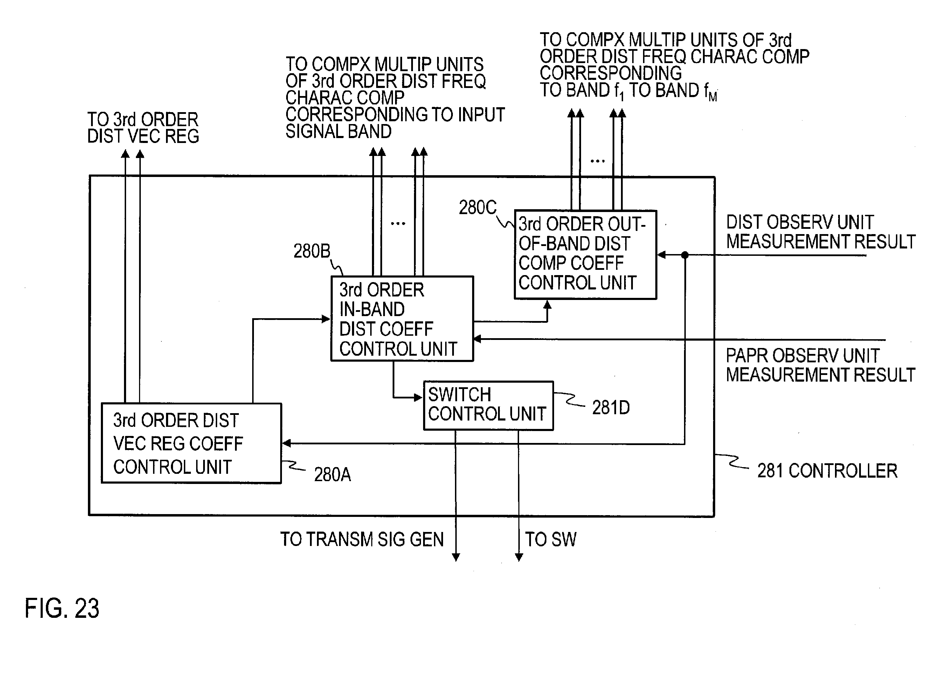

The configuration of the modification depicted in Fig. 22 is different from that of Fig. 19 in the addition of a transmission signal generating apparatus 500 composed of a transmission signal generator 50, the addition of a switch (SW) 201 for switching on and off on the preceding stage of the DAC 25, and the configuration of a controller 281. Further, a switch control unit 281D which switches an output signal for the transmission signal generator 50 and on and off of the SW 201 respectively is added to the controller 281 as depicted in Fig. 23, but the third order distortion vector regulator coefficient control unit 280A, the third order in-band distortion coefficient control unit 280B, the third order out-of-band distortion compensation coefficient control unit 280C are the same as those (that is, 280A, 280B, and 280C of Fig. 7) of the controller 280 of Fig. 19. The transmission signal generator 50 has a function of outputting a signal for performing communication with a mobile station or a base station, a function of outputting a pilot signal, and a function of repeatedly outputting arbitrary signal portion of arbitrary time length in a communication signal, in accordance with instruction provided from the controller 281. The SW 201 is disposed on the preceding stage of the DAC 25 so as to be effected simply in digital signal processing. However, when the SW 201 is desired to be configured by an analog circuit, the SW 201 may be interposed on an arbitrary position between the DAC 25 and an output terminal T$_{OUT}$.

Fig. 24 illustrates a flow of the third order in-band distortion coefficient adjustment processing S12A' performed by the third order in-band distortion coefficient control unit 280B.

[Third Order In-Band Distortion Coefficient Adjustment Processing (S12A')]

When the PAPR$_{OUT}$ notified from the PAPR observation unit 291 exceeds the threshold value, the third order in-band distortion coefficient control unit 280B turns off the SW 201 so as not to output the signal from the digital predistorter and notifies the switch control unit 281D so as to allow the transmission signal generator 50 to repeatedly output a signal portion at which PAPR$_{OUT}$ exceeds the threshold value until the third order in-band distortion coefficient adjustment processing (S12A') is ended (S12A0). The time length of one period of the signal portion to be generated is preliminarily determined. Subsequently, the phase value calculation processing (S12A1) of the third order in-band distortion coefficients employing the perturbation method is performed by using the phase value Y$_P$ which has been already set as an initial value, so as to obtain a phase value Y$_{P,MIN}$ at which PAPR becomes equal to or less than the threshold value. When PAPR does not become equal to or less than the threshold value even if the processing S12A1 is repeated designated number of times as is the case in Fig. 21, adjustment processing S12A2 of the third order in-band distortion coefficients employing the perturbation method is performed.

The processing S12A1 and the processing S12A2 are repeated preliminarily designated number of times (S12A3). When PAPR becomes equal to or less than the threshold value in either the processing S12A1 or the processing S12A2, the switch control unit 281D turns on the SW 201 and the signal used for the adjustment processing of the processing S12A' is outputted from the digital predistorter 200. Then, the switch control unit 281D is notified to switch output of the transmission signal generator 50 to the signal for performing communication with a mobile station or a base station (S12A4). When PAPR does not become equal to or less than the threshold value even if the processing S12A1 and the processing S12A2 are repeated designated number of times, a phase value and an amplitude value, among the set phase values and amplitude values, at which PAPR is the lowest are respectively set, and the processing is shifted to the processing S12A4. The rest is the same as the embodiment of Fig. 19.

[Third Embodiment]

There is a possibility that EVM (error vector magnitude) in output of the power amplifier 33 is degraded when PAPR is reduced by the present invention. The EVM is set to be equal to or less than a predetermined value in accordance with standards of various systems. For example, when a modulating method of each subcarrier is set to QPSK, it is required to set EVM to 17.5% or less, in the LTE. Therefore, in a third embodiment, the configuration that enables to reduce PAPR in a range in which EVM in an output signal of the digital predistorter is equal to or less than the standard value will be described.

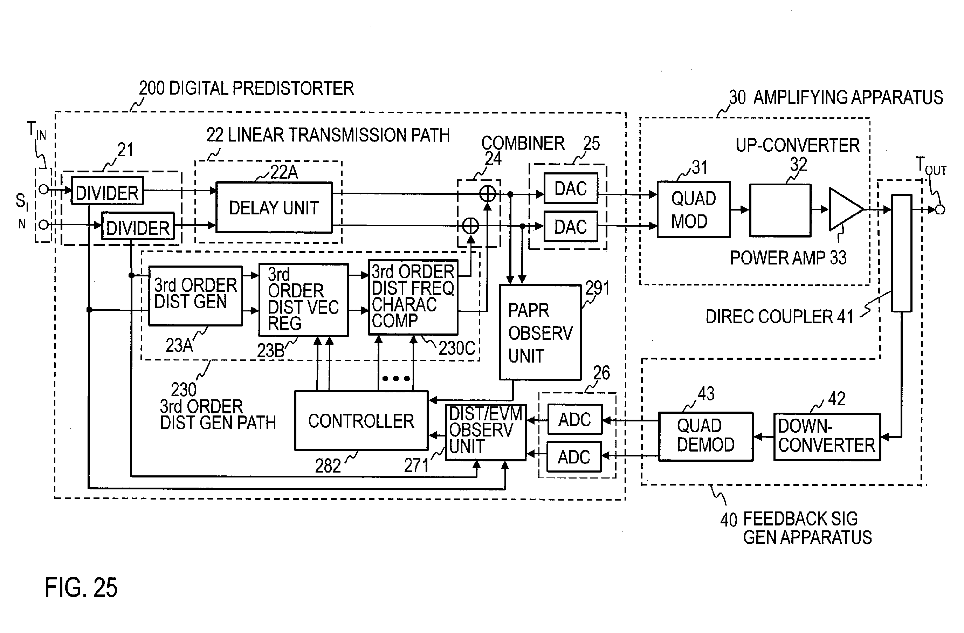

Fig. 25 illustrates a configuration example according to the third embodiment of the present invention. In this configuration, a distortion and EVM observation unit 271 which is provided with a function to measure EVM in addition to the function to measure distortion is used instead of the distortion observation unit 27 according to the second embodiment of Fig. 19. The distortion and EVM observation unit 271 demodulates an input signal $S_{IN}$ of the digital predistorter 200 and an output signal $S_{OUT}$ of the power amplifier 33 obtained via the feedback signal generating apparatus 40 respectively and compares the demodulation results so as to measure EVM. In order to measure EVM, the distortion and EVM observation unit 271 observes a signal for synchronization included in a transmission signal, so as to synchronize the input signal $S_{IN}$ of the digital predistorter 200 and the output signal $S_{OUT}$ of the power amplifier 33, respectively. Here, when a demodulation result on the i-th order in the input signal $S_{IN}$ of the digital predistorter 200 is denoted as Z (i), a demodulation result in the output signal $S_{OUT}$ of the power amplifier 33 is denoted as Z'(i), and averaging is performed over L points, EVM (%) is provided by:

$$ EVM = \sqrt{\frac{\sum_{i=0}^{L-1} |Z(i) - Z'(i)|^2}{\sum_{i=0}^{L-1} |Z(i)|^2}} \times 100 \qquad (8). $$

L denotes an integer which is predetermined and equal to or larger than 2.

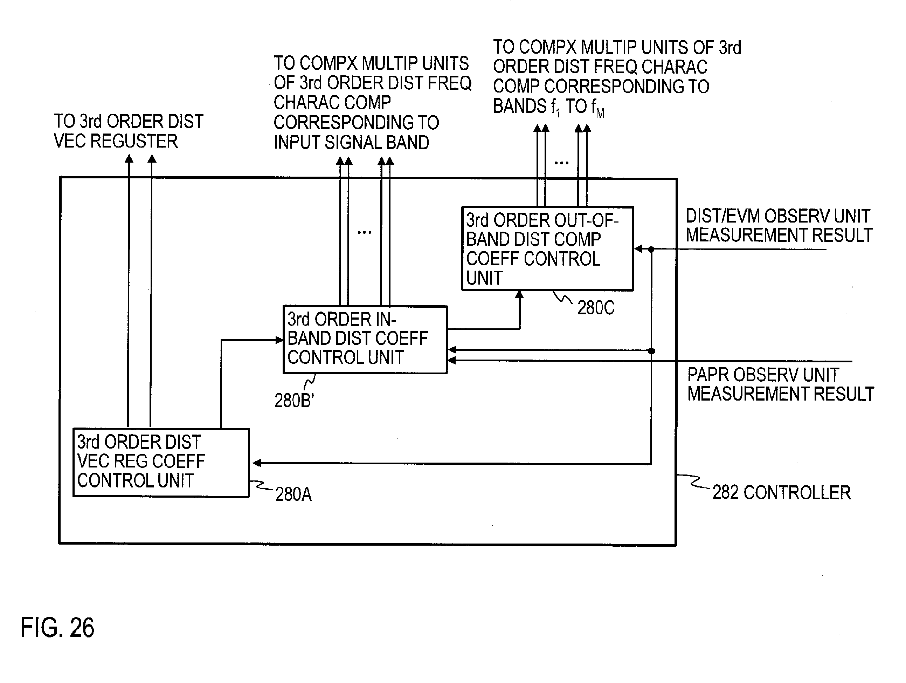

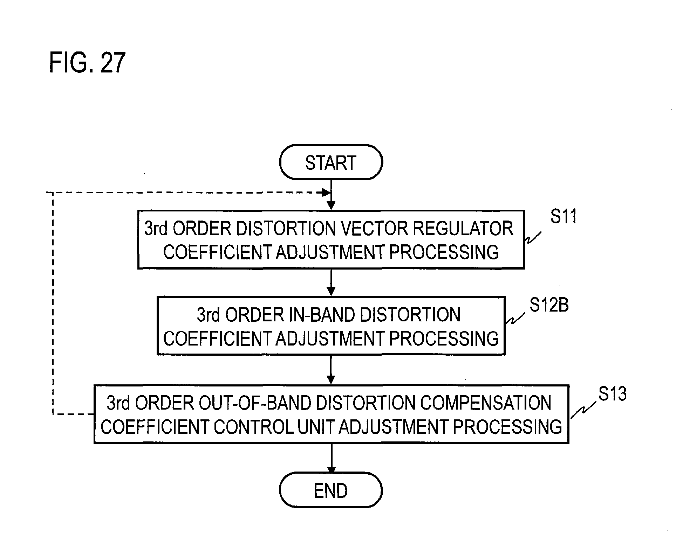

Fig. 26 illustrates the configuration of the controller 282. The controller 282 is different from the controller 280 of Fig. 7 in that not only a PAPR but also EVM which is measured by the distortion and EVM observation unit 271 are provided to the third order in-band distortion coefficient control unit 280B'. Fig. 27 illustrates a processing flow of the controller 282. Third order in-band distortion coefficient adjustment processing (S12B) performed by the third order in-band distortion coefficient control unit 280B' is different from other embodiments. The third order in-band distortion coefficient adjustment processing S12B will be described below. Other processing is the same as that of other embodiments, so that description thereof is omitted.

While the processing flow of the controller 282 illustrated in Fig. 27 is performed, a pilot signal is provided to the digital predistorter 200 as an input signal as is the case in the first embodiment. After the processing flow of the controller 282 is ended, switching to a signal for performing communication with a mobile station or a base station is performed as is the case in the first embodiment.

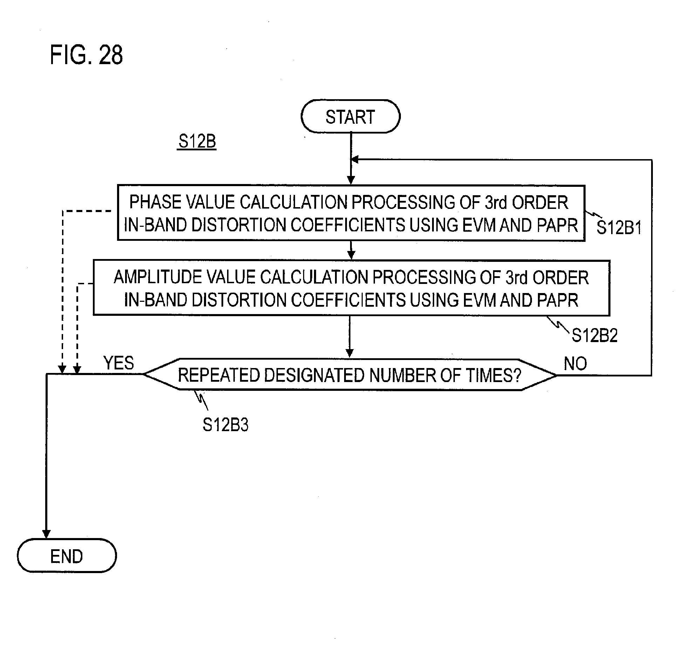

Fig. 28 illustrates a flow of the third order in-band distortion coefficient adjustment processing (S12B) performed by the third order in-band distortion coefficient control unit 280B'.

[Third Order In-Band Distortion Coefficient Adjustment Processing (S12B)]

The third order in-band distortion coefficient control unit 280B' receives notification of the phase value $X_{P,MIN}$ which is set in the third order distortion vector regulator 23B, from the third order distortion vector regulator coefficient control unit 280A. Subsequently, phase value calculation processing (S12B1) of the third order in-band distortion coefficients using EVM and PAPR described later is performed. Similarly, amplitude value calculation processing (S12B2) of the third order in-band distortion coefficients using EVM and PAPR is performed. When EVM exceeds a threshold value or $PAPR_{OUT}$ exceeds a threshold value after the processing S12B2, the processing S12B1 and the processing S12B2 are repeated designated number of times (S12B3). Then, the processing S12B is ended and the processing is shifted to the processing S 13 of Fig. 27.

When EVM becomes equal to or less than the threshold value and PAPR becomes equal to or less than the threshold value in either the processing S12B1 or the processing S12B2, the processing S12B is ended and the processing is shifted to the processing S 13 of Fig. 27.

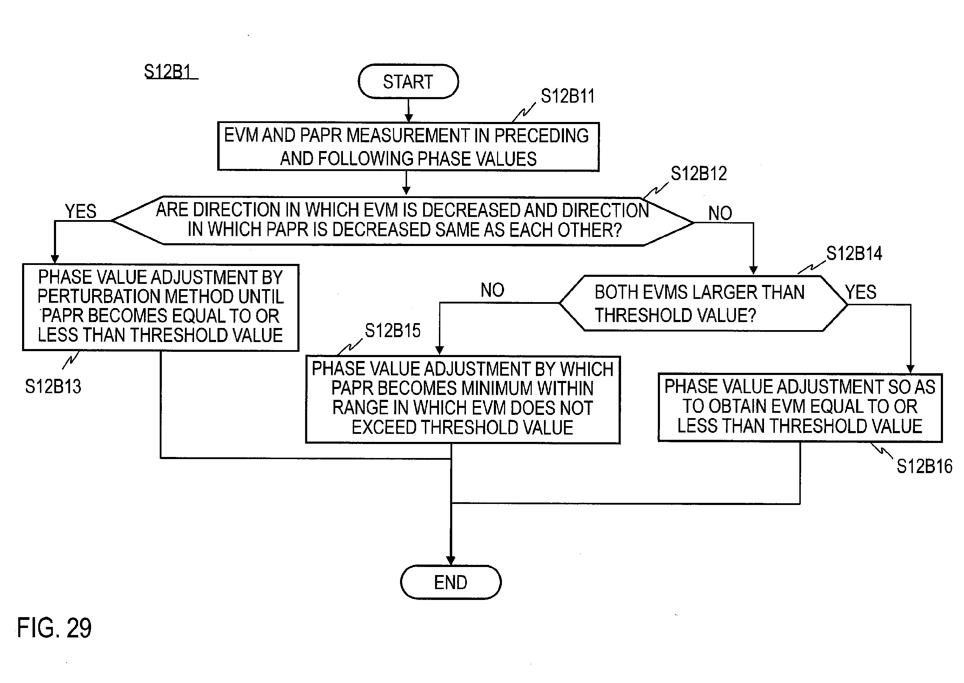

The phase value calculation processing (S12B1) of the third order in-band distortion coefficients using EVM and PAPR will be described with reference to Fig. 29. The amplitude value calculation processing (S12B2) of the third order in-band distortion coefficients using EVM and PAPR is the same as previous, so that the description of the latter is omitted.

[Phase Value Calculation Processing (S12B1) of Third Order In-Band Distortion Coefficients Using EVM and PAPR]

A phase value $Y_P$ (=$\pi$-$X_{P,MIN}$) is calculated and EVM ($E_{P,1}$, $E_{P,2}$) and PAPRs ($R_{P,1}$, $R_{P,2}$) of output signals (output signals of the combiner 240) of the digital predistorter 200 at two phase values which are before and after the $Y_P$ are respectively measured (S12B11). Subsequently, whether a direction in which EVM is decreased is accorded with a direction in which PAPR is decreased is determined (S12B12). When the directions are accorded with each other, a phase value at which PAPR becomes equal to or less than the threshold value in a direction in which PAPR is decreased, under a condition that EVM does not exceed the threshold value, is obtained by using the perturbation method (S12B13). When a phase value at which PAPR is equal to or less than the threshold value is not obtained in the processing S12B13, a phase value at which PAPR is the lowest among set phase values is set.

When the direction in which EVM is decreased and the direction in which PAPR is decreased are not accorded with each other in the processing S12B12, whether both of measured $E_{P,1}$ and $E_{P,2}$ are larger than the threshold value is determined (S12B14). When at least one of the $E_{P,1}$ and $E_{P,2}$ is equal to or less than the threshold value, a phase value at which PAPR becomes equal to or less than the threshold value in a direction in which PAPR is decreased, under the condition that EVM does not exceed the threshold value, is obtained by using the perturbation method (S12B15). When a phase value at which PAPR becomes equal to or less than the threshold value is not obtained in the processing S12B15, a phase value at which PAPR is the lowest among set phase values is set.

When both of the $E_{P,1}$ and $E_{P,2}$ are larger than the threshold value in the processing S12B14, a phase value at which EVM becomes equal to or less than the threshold value in a direction in which EVM is decreased is obtained by using the perturbation method (S12B16).

After the adjustment processing of Fig. 27 is ended and switching to a signal for performing communication with a mobile station or a base station is performed, an amplitude value and a phase value of the third order distortion vector regulator coefficients, a phase value and an amplitude value of the third order in-band distortion compensation coefficients, and amplitude values and phase values of the third order out-of-band distortion compensation coefficients are kept as values respectively obtained by using pilot signals until ACLR exceeds the threshold value again, and the processing of Fig. 27 is performed again by using pilot signals when ACLR exceeds the threshold value.

[Modification]

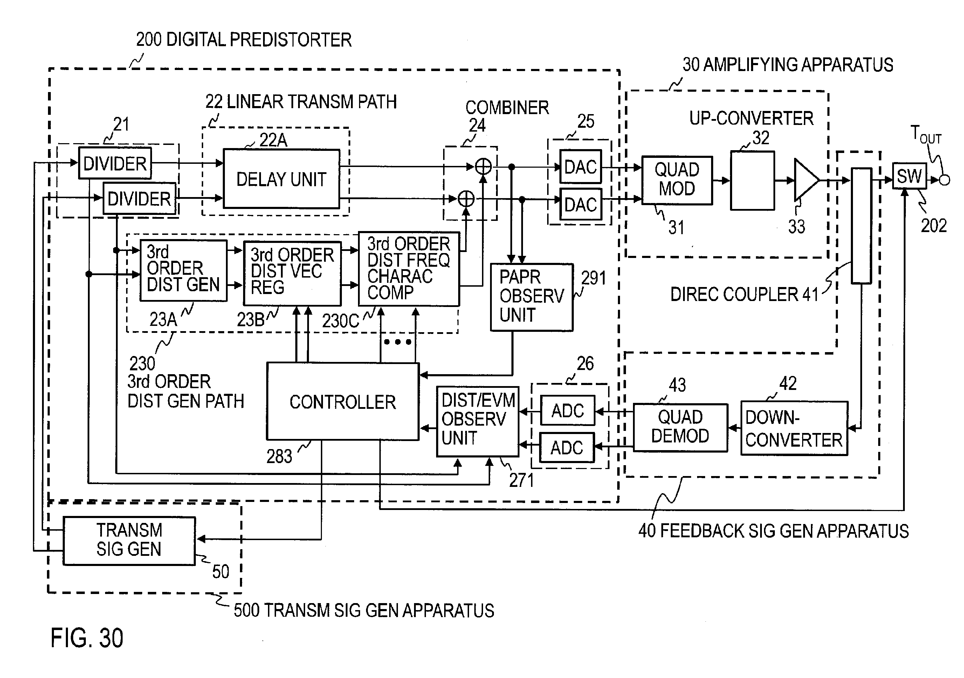

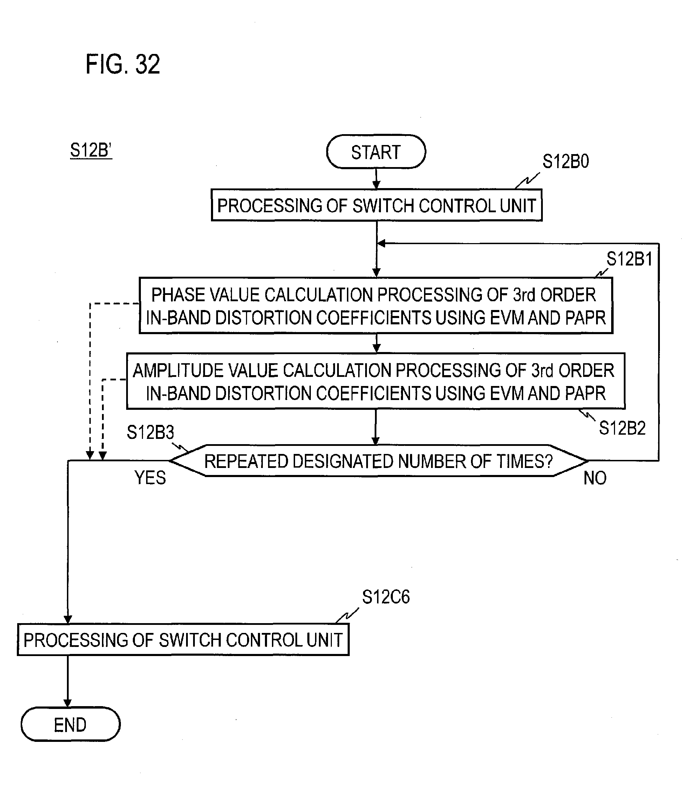

In a modification of Fig. 30, after the setting processing using pilot signals is ended in the embodiment of Fig. 25 and the input signal is switched from a pilot signal to a signal for performing communication with a mobile station or a base station, an amplitude value and a phase value of the third order distortion vector regulator coefficients and amplitude values and phase values of the third order out-of-band distortion compensation coefficients are kept as values respectively obtained by using pilot signals and only a phase value and an amplitude value of the third order in-band distortion coefficients are adjusted by the third order in-band distortion coefficient adjustment processing (S12B') of Fig. 32 described later, when $PAPR_{OUT}$ in output of the combiner 24 exceeds the threshold value. During the performance of the processing S12B', a transmission signal of a predetermined length including a portion in which the $PAPR_{OUT}$ exceeds the threshold value is repeatedly used. When ACLR exceeds the threshold value even when the $PAPR_{OUT}$ becomes equal to or less than the threshold value by the processing S12B', an amplitude value and a phase value of the third order distortion vector regulator coefficients, a phase value and an amplitude value of the third order in-band distortion coefficients, and amplitude values and phase values of the third order out-of-band distortion compensation coefficients are respectively readjusted by the method described in the embodiment of Fig. 25.

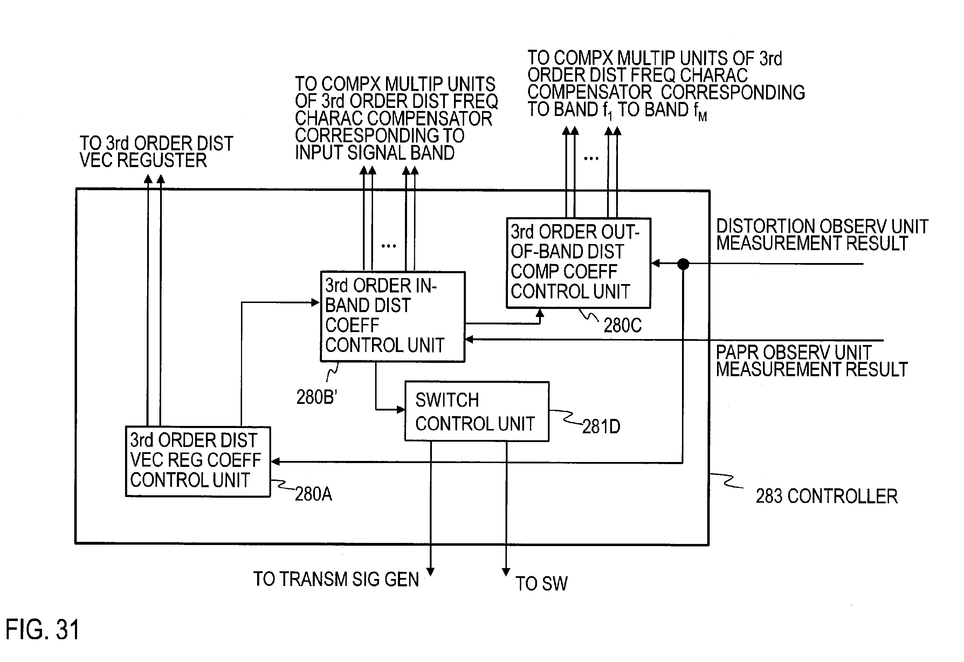

The configuration of the digital predistorter depicted in Fig. 30 is different from that of Fig. 25 in the addition of the transmission signal generating apparatus 500 composed of the transmission signal generator 50 depicted in Fig. 22, the addition of a switch (SW) 202 for switching on and off on the output side of the power amplifier 33, and the configuration of a controller 283. As depicted in Fig. 31, the controller 283 has such a configuration that the switch control unit 281D which switches an output signal for the transmission signal generator 50 and controls on and off of the SW 202 respectively is added to the controller 282 of Fig. 26 as is the case in Fig. 23, but the processing of the third order in-band distortion coefficient control unit 280B' is different from that of Fig. 23.

Fig. 32 illustrates a flow of the third order in-band distortion coefficient adjustment processing S12B' performed by the third order in-band distortion coefficient control unit 280B'.

[Third Order In-Band Distortion Coefficient Adjustment Processing (S12B')]

When the $PAPR_{OUT}$ notified from the PAPR observation unit 291 exceeds the threshold value, the third order in-band distortion coefficient control unit 280B' turns off the SW 202 so as not to output the signal from the digital predistorter and notifies the switch control unit 281D to allow the transmission signal generator 50 to repeatedly output a signal portion in which $PAPR_{OUT}$ exceeds the threshold value until the third order in-band distortion coefficient adjustment processing (S12B') is ended (S12BO). Subsequently, after the processing S12B1 is performed, the processing S12B2 is performed. The processing S12B1 and the processing S12B2 are the same as those of Fig. 28.

The processing S12B1 and the processing S12B2 are repeated preliminarily-designated number of times (S12B3). When EVM becomes equal to or less than the threshold value and PAPR becomes equal to or less than the threshold value in either the processing S12B1 or the processing S12B2, a phase value and an amplitude value at that time are stored, the switch control unit 281D turns on the SW 202, and the signal used in the adjustment processing of the processing S12B' is outputted from the digital predistorter 200. Then, the switch control unit 281D is notified to switch the output of the transmission signal generator 50 to a signal for performing communication with a mobile station or a base station (S12B4). When EVM does not become equal to or less than the threshold value and PAPR does not become equal to or less than the threshold value even if the processing S12B1 and the processing S12B2 are repeated designated number of times, a phase value and an amplitude value at which PAPR is the lowest in a range in which EVM becomes equal to or less than the threshold value among set phase values and amplitude values are respectively read out to be set, and the processing is shifted to the processing S12B4.

[Fourth Embodiment]

In mobile radio systems such as HSPA (high speed packet access) and LTE, scheduling, adaptive modulation for changing a modulation scheme or the like, and so forth are performed in accordance with a channel state between a base station and a terminal (a state of a propagation path). For example, in the LTE, scheduling and adaptive modulation are performed on the basis of a CQI (channel quality indicator) which is transmitted from a terminal side and indicates an index value of a channel state.

When the channel state is good, transmission quality is high. Therefore, there is a possibility to further reduce PAPR of the output signal of the digital predistorter. When PAPR can be reduced, efficiency of the power amplifier can be enhanced by decreasing bias of the power amplifier along with the reduction of PAPR. Hereinafter, a case where LTE is used as a radio system will be described as an example. Such a configuration will be described in which PAPR of an output signal of the digital predistorter is further reduced by setting the threshold value $PAPR_{TH}$ to have a smaller value when CQI is large (when the channel state is good). However, it is assumed that as CQI is larger, the channel state is better. When a radio system other than LTE is used, quality information which is referred to for performing adaptive modulation may be used in place of CQI as an index value of the channel state, for example.

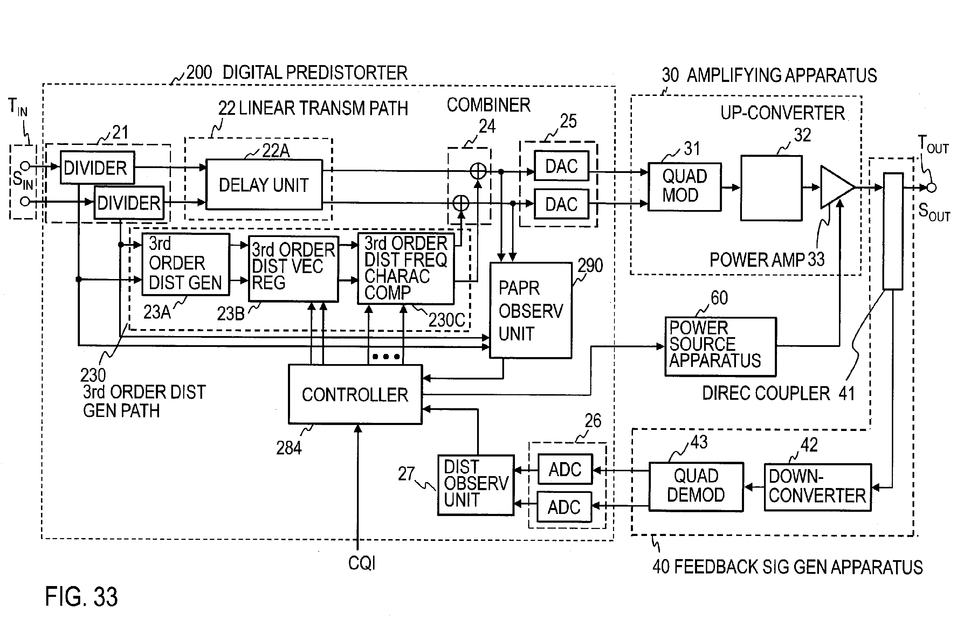

Fig. 33 illustrates a digital predistorter and peripheral devices of the digital predistorter according to a fourth embodiment of the present invention. In this configuration, a threshold value $PAPR_{TH}$ is dynamically changed on the basis of CQI, and the bias of the power amplifier 33 is changed along with $PAPR_{TH}$. Therefore, this configuration is different from the configuration of Fig. 5 in that CQI is inputted into a controller 284 and a power source apparatus 60 which changes the bias to be provided to the power amplifier 33 on the basis of instruction from the controller 284, is added.

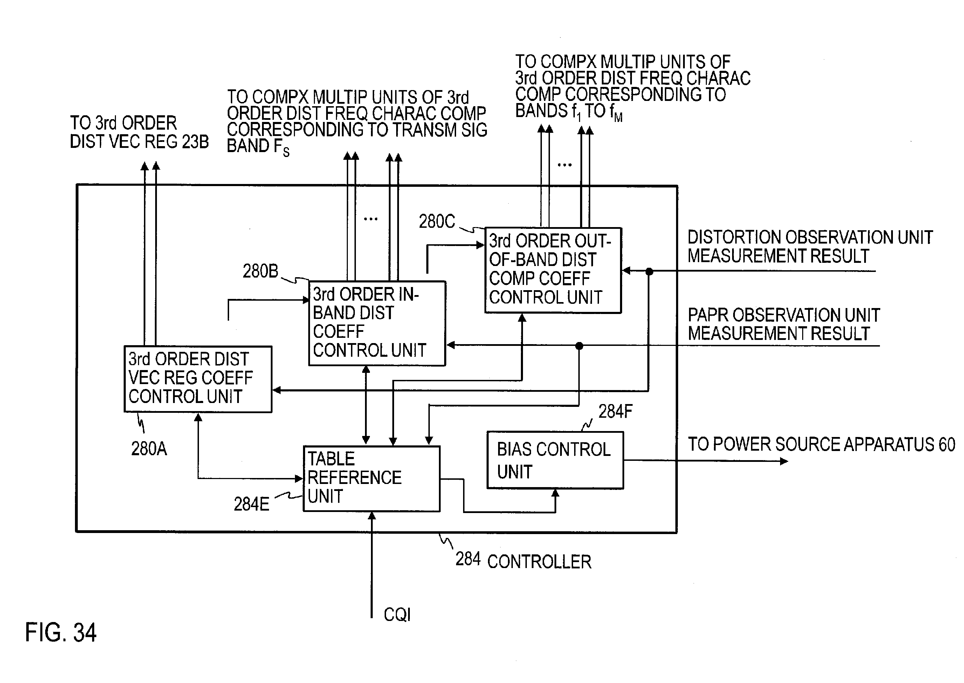

Fig. 34 illustrates the controller 284 of this configuration. This controller 284 includes a table reference unit 284E and a bias control unit 284F in addition to the third order distortion vector regulator coefficient control unit 280A, the third order in-band distortion coefficient control unit 280B, and the third order out-of-band distortion compensation coefficient control unit 280C. In the table reference unit 284E, a relationship between a CQI and a corresponding threshold value $PAPR_{TH}$ and a relationship between a threshold value $PAPR_{TH}$ and a corresponding bias value are preliminarily stored as tables. The bias control unit 284F instructs the power source apparatus 60 on a bias to be provided to the power amplifier 33. The table reference unit 28E reads out a threshold value $PAPR_{TH}$ corresponding to the provided CQI from the table and provides the threshold value $PAPR_{TH}$ to the third order in-band distortion coefficient control unit 280B. The third order in-band distortion coefficient control unit 280B calculates an amplitude value $Y_A$ from Formula (7) by using difference $\Delta PAPR=PAPR_{IN}-PAPR_{TH}$, between the provided threshold value $PAPR_{TH}$ and $PAPR_{IN}$ in the input signal observed by the PAPR observation unit 290, obtains a phase value $Y_P$ as $Y_P=\pi-X_{P,MIN}$ from the phase value $X_{P,MIN}$ set in the third order distortion vector adjustment as is the case with the processing of Fig. 13 described in the first embodiment, and sets the amplitude value $Y_A$ and the phase value $Y_P$ in the third order distortion frequency characteristic compensator 230C as third order in-band distortion coefficients. The table reference unit 284E further reads out a bias value corresponding to a threshold value $PAPR_{TH}$ corresponding to a CQI from the table and provides the bias value to the bias control unit 284F. The bias control unit 284F provides the provided bias value to the power source apparatus 60 and accordingly sets a bias in the power amplifier 33.

The relationship between CQI and a threshold value $PAPR_{TH}$ is such relationship that as CQI is increased, a threshold value $PAPR_{TH}$ is decreased. $PAPR_{TH}$ is preliminarily determined by measurement so as to be as small as possible with respect to CQI within a range in which a transmission property such as an error rate property is not largely deteriorated. The relationship between a threshold value $PAPR_{TH}$ and a bias value is such relationship that when a threshold value $PAPR_{TH}$ is decreased, a bias value is decreased. A bias value is preliminarily determined with respect to a set $PAPR_{TH}$ by measurement so that ACLR becomes equal to or less than the threshold value and efficiency of the power amplifier 33 becomes the highest. In the table reference unit 284E, the relationships determined as above are stored as tables. The relationship between CQI and a threshold value $PAPR_{TH}$ does not have to necessarily have a linear relationship and the threshold value $PAPR_{TH}$ may be reduced in a stair-like manner as CQI is increased, for example. Further, a threshold value $PAPR_{TH}$ is determined with respect to CQI and a bias value is determined with respect to a threshold value $PAPR_{TH}$, so that one table in which a threshold value $PAPR_{TH}$ and a bias value are provided to each CQI may be stored in the table reference unit 284E after all.

Thus, when a threshold value $PAPR_{TH}$ is decreased along with the increase of CQI and the bias of the power amplifier 33 is reduced along with the reduction of the threshold value $PAPR_{TH}$, there is a case where distortion components in power amplifier output which is observed by the distortion observation unit 27 are changed and as a result, the third order distortion vector regulator coefficients and the third order out-of-band distortion compensation coefficients at which ACLR becomes equal to or less than the threshold value are changed. Therefore, $PAPR_{TH}$, and third order distortion vector regulator coefficients and third order out-of-band distortion compensation coefficients at which ACLR becomes equal to or less than the threshold value at the bias at that time are preliminarily stored as a table in the table reference unit 284E. The third order distortion vector regulator coefficients and the third order out-of-band distortion compensation coefficients are preliminarily obtained respectively by using the above-mentioned method of the first embodiment. In this case as well, the third order distortion vector regulator coefficients and the third order out-of band distortion compensation coefficients corresponding to the threshold value $PAPR_{TH}$ may be provided as one table or as one table which is obtained by integration with the above-mentioned table of the threshold value $PAPR_{TH}$ and the bias value corresponding to CQI. Further, regarding the third order in-band distortion coefficients, an appropriate amplitude value $Y_A$, which is calculated by Formula (7) from difference $\Delta PAPR$ between each value which can be taken by $PAPR_{IN}$ and a corresponding threshold value $PAPR_{TH}$, may be preliminarily stored as a table in the table reference unit 284E as the third order in-band distortion coefficients.

When average power of signals outputted from the power amplifier is changed, $PAPR_{TH}$ with respect to CQI, a bias value, the third order distortion vector regulator coefficients, and the third order out-of band distortion compensation coefficients may be stored as a table in the table reference unit 284E for every average power which can be taken.

Setting with respect to the third order distortion vector regulator 23B and the third order distortion frequency characteristic compensator 230C is performed by the above-described processing of the first embodiment by using a threshold value $PAPR_{TH}$ and a bias value, which are preliminarily determined, as initial values in starting of a system including a predistorter and a power amplifier. When a CQI is inputted, a threshold value $PAPR_{TH}$ and a bias value that correspond to the CQI may be read out from the table of the table reference unit 284E so as to be respectively provided to the third order in-band distortion coefficient control unit 280B and the bias control unit 284F, and further, third order distortion vector regulator coefficients and third order out-of-band distortion compensation coefficients may be read out so as to be respectively provided to the third order distortion vector regulator coefficient control unit 280A and the third order out-of-band distortion compensation coefficient control unit 280C. When CQI is changed, processing speed can be more increased by using a value and coefficients which are read out from a table of the table reference unit 284E than a case where the third order distortion vector regulator coefficients and the third order out-of-band distortion compensation coefficients are newly obtained by the processing same as that of the first embodiment.

The case where a CQI is improved is described above, but a case where a channel state is adversely deteriorated can be also handled by preliminarily providing correspond threshold value $PAPR_{TH}$, a bias value, third order distortion vector regulator coefficients, and third order out-of-band distortion compensation coefficients in a range of a small CQI to the table of the table reference unit 284E.

The configuration of this embodiment may be applied to the configuration depicted in Fig. 22. At this time, a threshold value $PAPR_{TH}$, third order distortion vector regulator coefficients, third order out-of-band distortion compensation coefficients, and a bias value that correspond to CQI are respectively referred from the table reference unit 284E. The third order in-band distortion coefficients are adjusted by using the processing S12A' of Fig. 24 by the third order in-band distortion coefficient control unit 280B so that $PAPR_{OUT}$ becomes equal to or less than $PAPR_{TH}$ provided from the table reference unit 284E.

When the third order in-band distortion compensation coefficients to be set with respect to CQI and $PAPR_{IN}$ is preliminarily obtained by measurement by using the processing S12A', the third order in-band distortion compensation coefficients may be referred from the table reference unit 284E.

The configuration of this embodiment may be applied to the configuration depicted in Fig. 30. At this time, a threshold value $PAPR_{TH}$, third order distortion vector regulator coefficients, third order out-of-band distortion compensation coefficients, and a bias value corresponding to CQI are respectively referred from the table reference unit 284E and third order in-band distortion coefficients are adjusted by the processing S12B' of Fig. 32 so that $PAPRT_{OUT}$ becomes equal to or less than the $PAPR_{TH}$ provided from the table reference unit 284E. Here, such configuration may be employed that $PAPR_{TH}$ at which $PAPR_{OUT}$ of the digital predistorter output signal can be minimized in a range in which EVM is equal to or less than the threshold value is preliminarily stored in the table reference unit 284E, on the basis of a measurement result of EVM. Further, when third order in-band distortion coefficients to be set with respect to CQI and $PAPR_{IN}$ are preliminarily obtained by measurement by using the processing S12B' in a range in which EVM is equal to or less than the threshold value, the third order in-band distortion coefficients may be referred from the table reference unit 284E.
In a similar manner, the configuration of this embodiment may be applied to the configuration respectively depicted in Figs. 19 and 25.

Part or the whole of the configuration of the inventive power series digital predistorter which is depicted in the block diagrams in respective embodiments and modifications described above may be configured respectively of designated digital circuits, may be configured of a DSP (digital signal processor) and a FPGA (field programmable gate array), may be configured to execute a program in which the method described by the processing flow is written by a computer, or may be realized by a desired combination of these.

**Claims**

1. A power series digital predistorter that adds distortion compensation components for cancelling distortion components that are generated in a power amplifier, to an input signal, comprising:

   a liner transmission path configured to delay-transmit the input signal;
   a distortion generation path configured to include an N-th order distortion generator that generates an N-th order distortion component of the input signal, an N-th order distortion vector regulator that adjusts amplitude and a phase of the N-th order distortion component, and an N-th order distortion frequency characteristic compensator that converts output of the N-th order distortion vector regulator to a frequency domain and adjusts a phase and amplitude of each frequency component respectively, reverse-converts the adjusted frequency components to a time domain, and outputs an output of the N-th order distortion frequency characteristic compensator as the distortion compensation components;
   a combiner configured to combine output of the linear transmission path and output of the distortion generation path;
   a PAPR observation unit configured to calculate at least a ratio of average power to peak power $PAPR_{OUT}$ in an output signal of the combiner;
   a distortion observation unit configured to observe at least an N-th order distortion component included in output of the power amplifier; and
   a controller configured to adjust a phase value and an amplitude value with respect to the N-th order distortion vector regulator and the N-th order distortion frequency characteristic compensator on the basis of observation results of the PAPR observation unit and the distortion observation unit; wherein
   N is a predetermined odd number equal to or larger than 3, and
   the controller includes:

   an N-th order distortion vector regulator coefficient control unit configured to adjust a phase value and an amplitude value that are to be set in the N-th order distortion vector regulator so that N-th order distortion components observed by the distortion observation unit on an upper side and a lower side of a band of the input signal, hereinafter referred to as an input signal band, are decreased, an N-th order out-of band distortion compensation coefficient control unit configured to respectively adjust a phase value and an amplitude value for each frequency component in an outside of the input signal band in the frequency domain in the N-th order distortion frequency characteristic compensator so that N-th order distortion components on the upper side and the lower side of the input signal band observed by the distortion observation unit are decreased, and an N-th order in-band distortion coefficient control unit configured to respectively adjust a phase value and an amplitude value for each frequency component in the input signal band of the frequency domain in the N-th order distortion frequency characteristic compensator so that the ratio of average power to peak power $PAPR_{OUT}$ of the output signal calculated by the PAPR observation unit is decreased.

2. The power series digital predistorter according to Claim 1, wherein the N-th order out-of-band distortion compensation coefficient control unit is configured to divide an upper band and a lower band outside the input signal band of the frequency domain to M divided bands in total, M being a predetermined integer equal to or larger than 2, and set a phase value and an amplitude value for each of the divided bands so that N-th order distortion components in the upper side and the lower side are decreased.

3. The power series digital predistorter according to Claim 1 or 2, wherein the N-th order in-band distortion coefficient control unit is configured to calculate a phase value that is to be set for each frequency component in the input signal band of the frequency domain by the N-th order distortion frequency characteristic compensator on the basis of the phase value that is set to the N-th order distortion vector regulator.

4. The power series digital predistorter according to Claim 1 or 2, wherein the N-th order in-band distortion coefficient control unit is configured to calculate and set at least one of a phase value and an amplitude value for each frequency component in the input signal band of the frequency domain by the N-th order distortion frequency characteristic compensator by using a perturbation method or a function approximation method so that the ratio of average power to peak power $PAPR_{OUT}$ is decreased.

5. The power series digital predistorter according to any of Claims 1 to 4, wherein the PAPR observation unit is configured to further calculate a ratio of average power to peak power $PAPR_{IN}$ of the input signal, and the N-th order in-band distortion coefficient control unit is configured to calculate, from difference between the $PAPR_{IN}$ of the input signal and a predetermined threshold value $PAPR_{TH}$, an amplitude value that is to be set for each frequency component in the input signal band of the frequency domain by the N-th order distortion frequency characteristic compensator.

6. The power series digital predistorter according to any of Claims 1 to 5, further comprising:

a switch for turning on/off supply of output of the combiner to the power amplifier; wherein
the controller further includes a switch control unit that, when the ratio of average power to peak power $PAPR_{OUT}$ of output of the combiner, the ratio being obtained by the PAPR observation unit, exceeds a predetermined threshold value $PAPR_{TH}$, turns off the switch, controls a transmission signal generator to repeatedly generate, as the input signal, a predetermined length of a transmission signal including a portion in which $PAPR_{OUT}$ of the transmission signal exceeds a predetermined threshold value $PAPR_{TH}$, and controls the N-th order in-band distortion coefficient control unit to reset a phase value and an amplitude value that are to be set for frequency components in the input signal band of the frequency domain in the N-th order distortion frequency characteristic compensator so that the ratio of average power to peak power $PAPR_{OUT}$ becomes equal to or less than the threshold value $PAPR_{TH}$.

7. The power series digital predistorter according to any of Claims 1 to 5, wherein the distortion observation unit is configured to further calculate error vector magnitude, hereinafter referred to as EVM, from a demodulation result of output of the power amplifier and the input signal, and the N-th order in-band distortion coefficient control unit is configured to set a phase value and an amplitude value for frequency components in the input signal band in the N-th order distortion frequency characteristic compensator so that a ratio of average power to peak power $PAPR_{OUT}$ in output of the combiner observed by the PAPR observation unit, and EVM calculated by the distortion observation unit respectively become equal to or less than predetermined threshold values.

8. The power series digital predistorter according to Claim 7, wherein the controller further includes a switch control unit that, when the ratio of average power to peak power $PAPR_{OUT}$ of output of the combiner, the ratio being obtained by the PAPR observation unit, exceeds the predetermined threshold value $PAPR_{TH}$, turns off output of the power amplifier, controls a transmission signal generator to repeatedly generate, as the input signal, a predetermined length of a transmission signal including a portion in which $PAPR_{OUT}$ of the transmission signal exceeds a predetermined threshold value $PAPR_{TH}$, and controls the N-th order in-band distortion coefficient control unit to reset a phase value and an amplitude value that are to be set for frequency components in the input signal band of the frequency domain in the N-th order distortion frequency characteristic compensator so that the ratio of average power to peak power $PAPR_{OUT}$ becomes equal to or less than the threshold value $PAPR_{TH}$.

9. The power series digital predistorter according to any of Claims 1 to 8, wherein the controller further includes a table reference unit in which a threshold value $PAPR_{TH}$ and a bias value are preliminarily stored in a manner to be associated with an index value of a channel state between a base station and a terminal, and a bias control unit that sets a bias value that is read out from the table reference unit in accordance with an index value of the channel state, to a power source apparatus that provides a bias to the power amplifier, where the smaller the threshold value $PAPR_{TH}$ stored in the table reference unit is, the larger an index value of the channel state is, while the smaller the bias value stored in the table reference unit is, the smaller the threshold value $PAPR_{TH}$ is.

10. The power series digital predistorter according to Claim 9, wherein the N-th order in-band distortion coefficient control unit is configured to adjust a phase value and an amplitude value for each frequency component in the input signal band so that the ratio of average power to peak power $PAPR_{OUT}$ becomes equal to or less than the threshold value $PAPR_{TH}$ that is read out from the table reference unit in accordance with a channel state.

11. A control method of a power series digital predistorter according to Claim 1, in which processing of the controller, comprising:

(a) processing step of controlling a phase value and an amplitude value that are to be set in the N-th order distortion vector regulator by the N-th order distortion vector regulator coefficient control unit so that N-th order distortion components observed by the distortion observation unit on an upper band and a lower band of a band of the input signal, hereinafter referred to as an input signal band, are decreased;
(b) processing step of respectively adjusting a phase value and an amplitude value for each frequency component in an outside of the input signal band in the frequency domain in the N-th order distortion frequency characteristic compensator, by the N-th order out-of-band distortion compensation coefficient control unit so that N-th order distortion components on the upper band and the lower band of the input signal band observed by the distortion observation unit are decreased; and
(c) processing step of respectively setting a phase value and an amplitude value for each frequency component in the input signal band of the frequency domain in the N-th order distortion frequency characteristic compensator by the N-th order in-band distortion coefficient control unit so that the ratio of average power to peak power $PAPR_{OUT}$ of the output signal calculated by the PAPR observation unit is decreased.

FIG. 1

EP 2 592 750 A1

FIG. 2

3rd ORDER DIST FREQ
CHARAC COMPENSATOR
23C

23C2 J-POINT FFT UNIT

23C4 J-POINT IFFT UNIT

23C3

COMPX MULT UNIT J

23C3

COMPX MULT UNIT J-1

COMPX MULT UNIT J-n

23C3

COMPX MULT UNIT N

23C3

23C1
SERIAL-PARALLEL
CONVERSION UNIT

FROM CONTROLLER 28

23C5
PARALLEL-SERIAL
CONVERSION UNIT

FIG. 3

## FIG. 4

FIG. 5

EP 2 592 750 A1

3rd ORDER DIST FREQ
CHARAC COMPENSATOR
23C

23C2 J-POINT FFT UNIT

23C4 J-POINT IFFT UNIT

23C3
COMPX MULT UNIT J

23C3
COMPX MULT UNIT J-1

COMPX MULT UNIT J-n
23C3

COMPX MULT UNIT N
23C3

23C1
SERIAL-PARALLEL
CONVERSION UNIT

FROM CONTROLLER 28

23C5
PARALLEL-SERIAL
CONVERSION UNIT

FIG. 6

TO COMPX MULT UNITS OF 3rd ORDER DISTORTION FREQ CHARAC COMP CORRESPONDING TO BANDS $f_1$ TO $f_M$

DISTORTION OBSERVATION UNIT MEASUREMENT RESULT

PAPR OBSERVATION UNIT MEASUREMENT RESULT

3rd ORDER OUT-OF-BAND DISTORTION COMPENSATION COEFFICIENT CONTROL UNIT

280C

TO COMPLEX MULTIPLICATION UNIT OF 3rd ORDER DISTORTION FREQ CHARAC COMP CORRESPONDING TO INPUT SIGNAL BAND $F_S$

3rd ORDER IN-BAND DIST COMP COEFF CONTROL UNIT

280B

3rd ORDER DIST VEC LEG COEFF CONTROL UNIT

280A

280 CONTROLLER

TO 3rd ORDER DISTORTION VEC REGULATOR

FIG. 7

29

# FIG. 8

```
                    ┌─────────────┐
                    │    START    │
                    └─────────────┘
                           │
    ┌ ─ ─ ─ ─ ─ ─ ─ ─ ─ ─ ▼
    ┆  ┌──────────────────────────────────────┐        S11
    ┆  │ 3rd ORDER DISTORTION VECTOR REGULATOR │
    ┆  │   COEFFICIENT ADJUSTMENT PROCESSING   │
    ┆  └──────────────────────────────────────┘
    ┆                      │
    ┆  ┌──────────────────────────────────────┐        S12
    ┆  │  3rd ORDER IN-BAND DISTORTION COEFFICIENT │
    ┆  │         ADJUSTMENT PROCESSING         │
    ┆  └──────────────────────────────────────┘
    ┆                      │
    ┆  ┌──────────────────────────────────────┐      S13
    └ ─│  3rd ORDER OUT-OF-BAND DISTORTION     │
       │     COMPENSATION COEFFICIENT          │
       │       ADJUSTMENT PROCESSING           │
       └──────────────────────────────────────┘
                           │
                    ┌─────────────┐
                    │     END     │
                    └─────────────┘
```

FIG. 9

EP 2 592 750 A1

## FIG. 10

## FIG. 11

FIG. 12

<u>S11</u>

START

PHASE VALUE CALCULATION PROCESSING OF 3rd ORDER
DISTORTION VECTOR REGULATOR COEFFICIENTS —— S111

AMPLITUDE VALUE CALCULATION PROCESSING OF 3rd
ORDER DISTORTION VECTOR REGULATOR COEFFICIENTS —— S112

IS POWER OF DESIGNATED BAND EQUAL
TO OR LESS THAN THRESHOLD VALUE? —— S113

NO

YES

END

FIG. 13

<u>S12</u>

START

PHASE VALUE CALCULATION PROCESSING OF
3rd ORDER IN-BAND DISTORTION COEFFICIENTS —— S121

AMPLITUDE VALUE CALCULATION PROCESSING OF
3rd ORDER IN-BAND DISTORTION COEFFICIENTS —— S122

END

FIG. 14

S13

START

PHASE VALUE CALCULATION PROCESSING OF 3rd ORDER OUT-OF-BAND DISTORTION COMPENSATION COEFFICIENTS — S131

AMPLITUDE VALUE CALCULATION PROCESSING OF 3rd ORDER OUT-OF-BAND DISTORTION COMPENSATION COEFFICIENTS — S132

ACLR CALCULATION PROCESSING — S133

S134

IS ACLR EQUAL TO OR LESS THAN THRESHOLD VALUE?  NO

YES

END

FIG. 15A

AVERAGE OUTPUT POWER: 21.2 dBm

FIG. 15B

AVERAGE OUTPUT POWER: 22.1 dBm

FIG. 15C

AVERAGE OUTPUT POWER: 23.1 dBm

FIG. 16

FIG. 17

FIG. 18

FIG. 19

FIG. 20

```
                    ┌──────────┐
                    │  START   │
                    └────┬─────┘
                         │
   ┌ ─ ─ ─ ─ ─ ─ ─ ─ ─ ─ ▼ ─ ─ ─ ─ ─ ─ ─ ─ ─ ─ ─ ┐   S11
   │  ┌──────────────────────────────────────────┐
   │  │ 3rd ORDER DISTORTION VECTOR REGULATOR     │
   │  │    COEFFICIENT ADJUSTMENT PROCESSING      │
   │  └─────────────────┬────────────────────────┘
   │                    │                            S12A
   │  ┌─────────────────▼────────────────────────┐
   │  │       3rd ORDER IN-BAND DISTORTION        │
   │  │    COEFFICIENT ADJUSTMENT PROCESSING      │
   │  └─────────────────┬────────────────────────┘
   │                    │                            S13
   │  ┌─────────────────▼────────────────────────┐
   └──│ 3rd ORDER OUT-OF-BAND DISTORTION COMPENSATION │
      │ COEFFICIENT CONTROL UNIT ADJUSTMENT PROCESSING │
      └─────────────────┬────────────────────────┘
                        │
                   ┌────▼─────┐
                   │   END    │
                   └──────────┘
```

FIG. 21

S12A     ( START )

PHASE VALUE CALCULATION PROCESSING OF 3rd ORDER IN-BAND DISTORTION COEFFICIENTS USING PERTURBATION METHOD

S12A1

AMPLITUDE VALUE CALCULATION PROCESSING OF 3rd ORDER IN-BAND DISTORTION COEFFICIENT USING PERTURBATION METHOD

S12A2

S12A3

YES    REPEATED DESIGNATED NUMBER OF TIMES?    NO

( END )

FIG. 22

200 DIGITAL PREDISTORTER

30 AMPLIFYING APPARATUS

UP-CONVERTER 32

POWER AMP 33

31 QUAD MOD

DIREC COUPLER 41

40 FEEDBACK SIG GEN APPARATUS

DOWN-CONVERTER 42

QUAD DEMOD 43

T$_{OUT}$

25 DAC / DAC

201 SW / SW

26 ADC / ADC

291 PAPR OBSERV UNIT

COMBINER 24

DIST OBSERV UNIT 27

22 LINEAR TRANSM PATH

DELAY UNIT 22A

3rd ORDER DIST FREQ CHARAC COMP 230C

3rd ORDER DIST VEC REG 23B

CONTROLLER 281

21 DIVIDER / DIVIDER

3rd ORDER DIST GEN 23A

230 3rd ORDER DIST GEN PATH

TRANSM SIG GEN 50

500 TRANSM SIG GEN APPARATUS

FIG. 23

EP 2 592 750 A1

# FIG. 24

S12A'

START

S12A0 — PROCESSING OF SWITCH CONTROL UNIT

S12A1 — PHASE VALUE CALCULATION PROCESSING OF 3rd ORDER IN-BAND DISTORTION COEFFICIENTS USING PERTURBATION METHOD

AMPLITUDE VALUE CALCULATION PROCESSING OF 3rd ORDER IN-BAND DISTORTION COEFFICIENTS USING PERTURBATION METHOD

S12A2

S12A3 — REPEATED DESIGNATED NUMBER OF TIMES?    YES / NO

PROCESSING OF SWITCH CONTROL UNIT — S12A4

END

FIG. 25

TO COMPX MULTIP UNITS OF 3rd ORDER DIST FREQ CHARAC COMP CORRESPONDING TO BANDS $f_1$ TO $f_M$

TO COMPX MULTIP UNITS OF 3rd ORDER DIST FREQ CHARAC COMP CORRESPONDING TO INPUT SIGNAL BAND

TO 3rd ORDER DIST VEC REGUSTER

DIST/EVM OBSERV UNIT MEASUREMENT RESULT

PAPR OBSERV UNIT MEASUREMENT RESULT

282 CONTROLLER

3rd ORDER OUT-OF-BAND DIST COMP COEFF CONTROL UNIT

280C

3rd ORDER IN-BAND DIST COEFF CONTROL UNIT

280B'

280A

3rd ORDER DIST VEC REG COEFF CONTROL UNIT

FIG. 26

FIG. 27

```
                    ┌─────────────┐
                    │    START    │
                    └──────┬──────┘
                           │
    ┌─ ─ ─ ─ ─ ─ ─ ─ ─ ─ ─▼─ ─ ─ ─ ─ ─┐
    │  ┌──────────────────────────────────────┐         S11
    │  │ 3rd ORDER DISTORTION VECTOR REGULATOR │
    │  │  COEFFICIENT ADJUSTMENT PROCESSING    │
    │  └──────────────────┬───────────────────┘
    │                     │
    │        ┌────────────▼────────────────┐              S12B
    │        │ 3rd ORDER IN-BAND DISTORTION │
    │        │ COEFFICIENT ADJUSTMENT PROCESSING │
    │        └────────────┬────────────────┘
    │                     │
    │  ┌──────────────────▼───────────────────────┐       S13
    └──│ 3rd ORDER OUT-OF-BAND DISTORTION COMPENSATION │
       │ COEFFICIENT CONTROL UNIT ADJUSTMENT PROCESSING │
       └──────────────────┬───────────────────────┘
                          │
                    ┌─────▼──────┐
                    │    END     │
                    └────────────┘
```

FIG. 28

S12B

START

PHASE VALUE CALCULATION PROCESSING OF 3rd ORDER
IN-BAND DISTORTION COEFFICIENTS USING EVM AND PAPR — S12B1

AMPLITUDE VALUE CALCULATION PROCESSING OF 3rd ORDER
IN-BAND DISTORTION COEFFICIENTS USING EVM AND PAPR

S12B2

YES | REPEATED DESIGNATED NUMBER OF TIMES? | NO

S12B3

END

S12B1

FIG. 29

FIG. 30

FIG. 31

## FIG. 32

S12B'

```
                    ┌──────────┐
                    │  START   │
                    └──────────┘
                         │                          S12B0
              ┌──────────────────────────────────┐
              │ PROCESSING OF SWITCH CONTROL UNIT │
              └──────────────────────────────────┘
                         │
                         │◄─────────────────────────────┐
                         │                        S12B1  │
       ┌──────────────────────────────────────────────┐ │
       │ PHASE VALUE CALCULATION PROCESSING OF 3rd ORDER│ │
       │ IN-BAND DISTORTION COEFFICIENTS USING EVM AND PAPR│ │
       └──────────────────────────────────────────────┘ │
                         │                               │
       ┌──────────────────────────────────────────────┐ │
       │ AMPLITUDE VALUE CALCULATION PROCESSING OF 3rd ORDER│ │
       │ IN-BAND DISTORTION COEFFICIENTS USING EVM AND PAPR│ │
       └──────────────────────────────────────────────┘ │
                         │                        S12B2  │
         S12B3           │                               │
       ◄─────< REPEATED DESIGNATED NUMBER OF TIMES? >────┘
         YES                                        NO
```

S12C6

PROCESSING OF SWITCH CONTROL UNIT

END

FIG. 33

EP 2 592 750 A1

EP 2 592 750 A1

TO 3rd ORDER
DIST VEC REG 23B

TO COMPX MULTIP UNITS OF 3rd
ORDER DIST FREQ CHARAC COMP
CORRESPONDING TO TRANSM SIG
BAND $F_S$

TO COMPX MULTIP UNITS OF
3rd ORDER DIST FREQ CHARAC
COMP CORRESPONDING TO
BANDS $f_1$ TO $f_M$

280C

3rd ORDER OUT-
OF-BAND DIST
COMP COEFF
CONTROL UNIT

DISTORTION OBSERVATION UNIT
MEASUREMENT RESULT

280B

3rd ORDER IN-
BAND DIST
COEFF
CONTROL UNIT

PAPR OBSERVATION UNIT
MEASUREMENT RESULT

3rd ORDER DIST
VEC REG COEFF
CONTROL UNIT

280A

284F

BIAS CONTROL
UNIT

TO POWER SOURCE APPARATUS 60

TABLE
REFERENCE
UNIT

284E

284 CONTROLLER

CQI

FIG. 34

<table>
<tr><td colspan="2" align="center">**INTERNATIONAL SEARCH REPORT**</td><td colspan="2">International application No.<br>PCT/JP2012/053213</td></tr>
</table>

A.  CLASSIFICATION OF SUBJECT MATTER
*H03F1/32*(2006.01)i, *H03F3/189*(2006.01)i, *H03F3/24*(2006.01)i, *H04B1/04* (2006.01)i, *H04J11/00*(2006.01)i, *H04L27/01*(2006.01)i, *H04L27/20*(2006.01)i

According to International Patent Classification (IPC) or to both national classification and IPC

B.  FIELDS SEARCHED

Minimum documentation searched (classification system followed by classification symbols)
H03F1/32, H03F3/189, H03F3/24, H04B1/04, H04J11/00, H04L27/01, H04L27/20

Documentation searched other than minimum documentation to the extent that such documents are included in the fields searched
Jitsuyo Shinan Koho            1922-1996      Jitsuyo Shinan Toroku Koho    1996-2012
Kokai Jitsuyo Shinan Koho      1971-2012      Toroku Jitsuyo Shinan Koho    1994-2012

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 2004-247855 A  (Matsushita Electric Industrial Co., Ltd.), 02 September 2004 (02.09.2004), fig. 1; paragraphs [0083] to [0085] (Family: none) | 1-11 |
| A | JP 2011-4387 A  (NTT Docomo Inc.), 06 January 2011 (06.01.2011), fig. 21 & US 2010/0295612 A1     & EP 2254241 A2 & CN 101895260 A         & KR 10-2010-0126221 A | 1-11 |
| A | JP 2010-93785 A  (NTT Docomo Inc.), 22 April 2010 (22.04.2010), fig. 6 & US 2010/0060356 A1     & EP 2164171 A2 & CN 101674054 A         & KR 10-2010-0030583 A | 1-11 |

[X]  Further documents are listed in the continuation of Box C.     [ ]  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    17 April, 2012 (17.04.12) | Date of mailing of the international search report<br>    24 April, 2012 (24.04.12) |
|---|---|
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2012/053213 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2003-174332 A  (Hitachi, Ltd.),<br>20 June 2003 (20.06.2003),<br>fig. 2; paragraph [0018]<br>& US 2003/0108120 A1    & CN 1423496 A | 1-11 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. MIZUTA ; Y. SUZUKI ; S. NARAHASHI ; Y. YAMAO.** A New Adjustment Method for the Frequency-Dependent IMD Compensator of the Digital Predistortion Linearizer. *IEEE Radio and Wireless Symposium 2006,* January 2006, 255-258
- **XIAODONG LI ; CIMINI, L.J., JR.** Effects of clipping and filtering on the performance of OFDM. *47th IEEE Vehicular Technology Conference 1997,* May 1997, 1634-1638

- **T. NOJIMA ; T. KONNO.** Cuber Predistortion Linearizer for Relay Equipment in 800 MHz Band Land Mobile Telephone System. *IEEE Transactions on vehicular technology,* 1985, vol. 34 (4), 169-177
- **J. OHKAWARA ; Y. SUZUKI ; S. NARAHASHI.** Fast Calculation Scheme for Frequency Characteristic Compensator of Digital Predistortion Linearizer. *IEEE Vehicular Technology Conference Spring 2009, proceedings,* April 2009